(19) Europäisches Patentamt
European Patent Office
Office européen des brevets

(11) EP 4 679 489 A1

(12) **EUROPEAN PATENT APPLICATION**
published in accordance with Art. 153(4) EPC

(43) Date of publication:
**14.01.2026 Bulletin 2026/03**

(21) Application number: **24770809.2**

(22) Date of filing: **08.03.2024**

(51) International Patent Classification (IPC):
***H01L 21/02*** (2006.01) ***C09J 11/06*** (2006.01)
***C09J 11/08*** (2006.01) ***C09J 183/04*** (2006.01)
***C09J 183/05*** (2006.01)

(52) Cooperative Patent Classification (CPC):
**C09J 11/06; C09J 11/08; C09J 183/04; H01L 21/02**

(86) International application number:
**PCT/JP2024/009179**

(87) International publication number:
**WO 2024/190703 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 JP 2023037810**

(71) Applicant: **SHIN-ETSU CHEMICAL CO., LTD.**
**Tokyo 1000005 (JP)**

(72) Inventors:
- **SUGO Michihiro**
  **Annaka-shi, Gunma 379-0224 (JP)**
- **YAMAKI Masahiro**
  **Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

# (54) TEMPORARY ADHESIVE CONTAINING SILICONE-BASED RESIN, AND PROCESSING METHOD FOR SUBSTRATE WITH CIRCUIT

(57) The present invention is a silicone-based resin-containing temporary adhesive containing a silicone-based resin, configured to temporarily adhere a semiconductor substrate to a support, in which a dissolution rate of a temporary adhesive layer formed of the temporary adhesive is 20 µm/min or more, as measured by attaching the semiconductor substrate to the support via the temporary adhesive layer, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by mass of tetrabutylammonium fluoride. Thus, the present invention provides a silicone-based resin-containing temporary adhesive configured to facilitate bonding between a support and a substrate, enable a heavily stepped substrate to be formed with a uniform film thickness, exhibit high compatibility with steps of forming a TSV and forming a wiring on the wafer back surface, allow easy peeling of the substrate from the support, and enable effective removal of an adhesive layer without contaminating the substrate, thereby enhancing productivity of thin substrates.

EP 4 679 489 A1

## Description

### TECHNICAL FIELD

The present invention relates to a silicone-based resin-containing temporary adhesive and a method for processing a circuit substrate.

### BACKGROUND ART

Three-dimensional semiconductor packaging has become essential for accomplishing even higher density and higher capacity. A three-dimensional packaging technology is a semiconductor fabrication technology for thinning a semiconductor chip, and connecting the chip to another chip using a through silicon via (TSV) to form a multilayer. In order to realize this technology, a step of thinning a substrate configured to have a semiconductor circuit formed thereon by grinding a non-circuit-formed surface (also referred to as "back surface") of the substrate to form an electrode including a TSV on the back surface is required. In the step of grinding the back surface of a silicon substrate, a protective tape for the back surface is conventionally attached to a back side of the surface to be ground to prevent wafer breakage during grinding. However, this tape uses an organic resin film as a support base material, which has flexibility but inadequate strength and heat resistance. Thus, the tape is not suited to the steps of forming a TSV and forming a wiring layer on the back surface.

In this context, there has been proposed a system in which a semiconductor substrate is bonded to a support made of silicon, glass, or the like through an adhesive layer to sufficiently withstand the steps of grinding the back surface and forming a TSV or an electrode on the back surface. The important point here is the adhesive layer employed to bond the substrate to the support. The adhesive layer requires sufficient durability to bond the substrate to the support without gaps and to withstand subsequent steps, while finally allowing facile peeling of a thin wafer from the support. The adhesive layer, which is finally peeled off, is hence referred to as a "temporary adhesive layer" (or temporary adhesive agent layer) herein.

With respect to the conventionally known temporary adhesive layer and a method of peeling this layer, a technique of using a hydrocarbon based hot-melt compound as an adhesive to perform bonding and/or peeling in a heat-molten state has been proposed (Patent Document 1). This technique is simple because of control only by heat, but thermal stability is insufficient at a high temperature exceeding 200°C, and thus the applicable range is limited.

Furthermore, exposure to high temperatures may lead to thermal oxidation or similar effects, significantly degrading the cleanability of the adhesive layer and resulting in reduced cleaning rates and generation of cleaning residues.

### CITATION LIST

### PATENT LITERATURE

Patent Document 1: JP 2003-177528 A

### SUMMARY OF INVENTION

### TECHNICAL PROBLEM

The present invention has been made in view of the above-described problems, and an object thereof is to provide a silicone-based resin-containing temporary adhesive and a method for processing a circuit substrate that facilitate bonding between a support and a substrate, enable a heavily stepped substrate to be formed with a uniform film thickness, exhibit high compatibility with steps of forming a TSV and forming a wiring on the wafer back surface, allow facile peeling of the substrate from the support, and enable effective removal of an adhesive layer without contaminating the substrate, thereby enhancing the productivity of thin substrates.

### SOLUTION TO PROBLEM

To achieve the object, the present invention provides a silicone-based resin-containing temporary adhesive containing a silicone-based resin, configured to temporarily adhere a semiconductor substrate to a support, in which a dissolution rate of a temporary adhesive layer formed of the temporary adhesive is 20 μm/min or more, as measured by attaching the semiconductor substrate to the support via the temporary adhesive layer, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by

mass of tetrabutylammonium fluoride.

Such a silicone-based resin-containing temporary adhesive, owing to the flexibility and excellent heat resistance of a silicone resin, is applicable to a wide range of semiconductor film-forming processes, highly resistant to chemical vapor deposition (CVD), and capable of forming a temporary adhesive agent layer with high film thickness uniformity even on a stepped wafer. By virtue of the film thickness uniformity, a uniform thin wafer having a thickness of 50 μm or less can be easily fabricated. Furthermore, after the fabrication of a thin wafer, the wafer can be easily peeled off from the support, for example, at room temperature. In addition, a silicone-based resin-containing temporary adhesive having the above dissolution rate enables effective removal of the adhesive layer without contaminating the substrate, thereby enhancing the productivity of thin substrates.

In this case, the proportion of dimethylsiloxane units in a nonvolatile component of the silicone-based resin-containing temporary adhesive is preferably 20% by mass or more.

Such a proportion of dimethylsiloxane units can further increase the dissolution rate of the temporary adhesive layer formed of the temporary adhesive.

Preferably, the silicone-based resin-containing temporary adhesive of the present invention also includes a heat resistance enhancer.

By virtue of the inclusion of a heat resistance enhancer, the silicone-based resin-containing temporary adhesive is able to retain a high dissolution rate in solvent even after being subjected to high-temperature treatment.

In addition, the silicone-based resin is preferably a curable silicone resin, the curable silicone resin being formulated as a composition including:

(A) an organopolysiloxane having two or more alkenyl groups per molecule;
(B) an organohydrogenpolysiloxane having two or more silicon atom-bonded hydrogen atoms (Si-H groups) per molecule; and
(C) a platinum-based catalyst,

in such an amount that a molar ratio of the Si-H groups in the component (B) to the alkenyl groups in the component (A) is from 0.3 to 10.

The use of such a curable silicone resin as the silicone-based resin-containing temporary adhesive enables more effective retention of a high dissolution rate in solvent following high-temperature treatment.

The silicone-based resin-containing temporary adhesive is also preferably used in combination with a laser release agent when the semiconductor substrate is temporarily adhered to the support.

Thus, temporary adhesion in combination with a laser release agent allows more facile peeling using a laser.

The present invention also provides a method for processing a circuit substrate, including the steps of:

(a) providing a laminate comprising a circuit substrate as the semiconductor substrate and the support, which are temporarily adhered to each other via a silicone-based resin layer formed using the silicone-based resin-containing temporary adhesive and a laser release layer formed using the laser release agent;
(b) processing a back surface of the laminate;
(c) separating the support from the laminate by laser irradiation from a support side; and
(d) removing the silicone-based resin layer and the laser release layer from the separated laminate using a cleaning solution having a temperature of 40°C to 60°C to take out only the circuit substrate.

Such a method for processing a circuit substrate, which utilizes a silicone-based resin-containing temporary adhesive that has a high dissolution rate even after being subjected to high-temperature treatment as described above, enables effective removal of the adhesive layer without contaminating the substrate, thereby enhancing the productivity of thin substrates.

ADVANTAGEOUS EFFECTS OF INVENTION

The present invention, owing to the flexibility and excellent heat resistance of the silicone resin, is applicable to a wide range of semiconductor film-forming processes, highly resistant to chemical vapor deposition (CVD), and capable of forming a temporary adhesive agent layer with high film thickness uniformity even on a stepped wafer. By virtue of the film thickness uniformity, a uniform thin wafer having a thickness of 50 μm or less can be easily fabricated. Furthermore, after the fabrication of a thin wafer, the wafer can be easily peeled off from the support, for example, at room temperature. In addition, a silicone-based resin-containing temporary adhesive having the above dissolution rate enables effective removal of the adhesive layer without contaminating the substrate, thereby enhancing the productivity of thin substrates.

## DESCRIPTION OF EMBODIMENTS

As described above, there has been a demand for a silicone-based resin-containing temporary adhesive configured to facilitate bonding between a support and a substrate, enable a heavily stepped substrate to be formed with a uniform film thickness, exhibit high compatibility with steps of forming a TSV and forming a wiring on the wafer back surface, allow facile separation of the substrate from the support, and enable effective removal of an adhesive layer without contaminating the substrate, thereby enhancing the productivity of thin substrates.

As a result of intensive studies to achieve the above-described object, the present inventors have found that the object can be achieved by using a silicone-containing temporary adhesive having a dissolution rate of 20 μm/min or more, as determined by attaching a semiconductor substrate to a support via a temporary adhesive layer formed of a temporary adhesive, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by mass of tetramethylammonium fluoride, and have thus completed the present invention.

In other words, the present invention is a silicone-based resin-containing temporary adhesive containing a silicone-based resin, configured to temporarily adhere a semiconductor substrate to a support, in which a dissolution rate of a temporary adhesive layer formed of the temporary adhesive is 20 μm/min or more, as measured by attaching the semiconductor substrate to the support via the temporary adhesive layer, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by mass of tetrabutylammonium fluoride.

Hereinafter, the present invention is described in detail, but the present invention is not limited thereto.

First, the support and the semiconductor substrate (wafer) to be temporarily adhered to each other using the silicone-based resin-containing temporary adhesive of the present invention is described.

### [Support]

Examples of the support to be temporarily adhered using the silicone-based resin-containing temporary adhesive material of the present invention include a transparent substrate, a silicon wafer, and a ceramic substrate, and a transparent substrate is preferred from the viewpoint of transmissivity of a laser to be irradiated when the support is peeled off. The transparent substrate to be used is usually a glass substrate or a quartz substrate, and the thickness thereof is usually preferably from 300 to 1,000 μm, more preferably from 500 to 800 μm.

### [Semiconductor Substrate (Wafer)]

The semiconductor substrate is also referred to as a semiconductor wafer or simply a wafer. Examples of the wafer include a silicon wafer, a germanium wafer, a gallium-arsenic wafer, a gallium-phosphorus wafer, and a gallium-arsenic-aluminum wafer. Although not particularly limited, the thickness of the wafer is usually preferably from 600 to 800 μm, more preferably from 625 to 775 μm. A circuit substrate is fabricated by processing such a wafer to form a circuit.

The silicone-based resin-containing temporary adhesive material of the present invention is preferably used in combination with a laser release agent when the semiconductor substrate is temporarily adhered to the support. The laser release agent is described.

### [Laser Release Agent]

The laser release layer formed using a laser release agent includes a resin containing a fused ring in the main chain and serves as a light-shielding resin layer (light-shielding layer). The transmittance of light at a wavelength of 355 nm is preferably 20% or less, more preferably 18% or less, and still more preferably from 0 to 15%. In addition, the laser release layer has an absorption maximum wavelength of preferably from 300 to 500 nm, more preferably from 300 to 400 nm. Furthermore, the laser release layer preferably has a light transmittance of 20% or less at a wavelength of 300 to 500 nm.

From the viewpoint of heat resistance, adhesion, chemical resistance, and the like, the resin contained in the laser release layer (hereinafter, also referred to as "resin layer I") is preferably composed of a cured product of a resin composition (laser release agent, hereinafter, also referred to as "resin composition I") containing a resin including a repeating unit represented by formula (1) (hereinafter, also referred to as "resin I"). As the repeating unit represented by formula (1), only one type may be included, or two or more thereof may be included.

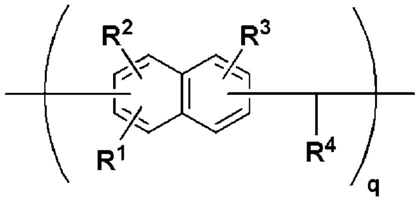

(1)

In formula (1), $R^1$ to $R^3$ are each independently a hydrogen atom, a hydroxy group, or a monovalent organic group having 1 to 20 carbon atoms, preferably 1 to 10 carbon atoms, provided that at least one of $R^1$ to $R^3$ is a hydroxy group.

Examples of the monovalent organic group include: linear, branched, or cyclic alkyl groups having 1 to 20 carbon atoms, such as a methyl group, an ethyl group, an n-propyl group, an isopropyl group, an n-butyl group, a sec-butyl group, a tert-butyl group, an n-pentyl group, a neopentyl group, an n-hexyl group, an n-heptyl group, an n-octyl group, an n-nonyl group, an n-decyl group, an n-dodecyl group, an n-pentadecyl group, an n-icosyl group, a cyclopentyl group, a cyclohexyl group, a cyclopentylmethyl group, a cyclohexylmethyl group, a cyclopentylethyl group, a cyclohexylethyl group, a cyclopentylbutyl group, a cyclohexylbutyl group, and an adamantyl group; linear, branched, or cyclic alkoxy groups having 1 to 5 carbon atoms, such as a methoxy group; epoxy group-containing groups such as a glycidyloxy group; and aryl groups such as a phenyl group and a naphthyl group. $R^1$ to $R^3$ are each preferably a hydrogen atom, a hydroxy group, a methyl group, or the like.

In formula (1), $R^4$ is a hydrogen atom or a monovalent organic group having 1 to 30 carbon atoms, preferably 1 to 10 carbon atoms, which optionally has a substituent. Examples of the monovalent organic group represented by $R^4$ include an alkyl group, a phenyl group, a naphthyl group, an anthracenyl group, and a norbornyl group, and a part of the hydrogen atoms in these groups may be substituted with an alkyl group, an aryl group, an aldehyde group, a halogen atom, a nitro group, a nitrile group, a hydroxy group, or the like.

The resin I can be obtained usually by subjecting naphthol or a derivative thereof to a polycondensation reaction with an aldehyde compound using an acid or a base as a catalyst in the presence or absence of a solvent at room temperature or, if necessary, under cooling or heating.

Examples of the naphthol or a derivative thereof include 1-naphthol, 2-naphthol, 2-methyl-1-naphthol, 4-methoxy-1-naphthol, 7-methoxy-2-naphthol, 1,2-dihydroxynaphthalene, 1,3-dihydroxynaphthalene, 2,3-dihydroxynaphthalene, 1,4-dihydroxynaphthalene, 1,5-dihydroxynaphthalene, 1,6-dihydroxynaphthalene, 2,6-dihydroxynaphthalene, 1,7-dihydroxynaphthalene, 2,7-dihydroxynaphthalene, 1,8-dihydroxynaphthalene, 5-amino-1-naphthol, 2-methoxycarbonyl-1-naphthol, 1-(4-hydroxyphenyl) naphthalene, 6-(4-hydroxyphenyl)-2-naphthol, 6-(cyclohexyl)-2-naphthol, 1,1'-bi-2-naphthol, 6,6'-bi-2-naphthol, 9,9-bis(6-hydroxy-2-naphthyl) fluorene, 6-hydroxy-2-vinylnaphthalene, 1-hydroxymethylnaphthalene, and 2-hydroxymethylnaphthalene. The naphthol or a derivative thereof may be used singly or in combination with two or more thereof.

Examples of the aldehyde compound include a compound represented by the following formula (2):

$$R^4\text{-CHO} \qquad (2)$$

wherein $R^4$ is the same as above.

Examples of the aldehyde compound represented by formula (2) include formaldehyde, trioxane, paraformaldehyde, acetaldehyde, propylaldehyde, adamantanecarboaldehyde, benzaldehyde, phenylacetaldehyde, α-phenylpropylaldehyde, β-phenylpropylaldehyde, o-chlorobenzaldehyde, m-chlorobenzaldehyde, p-chlorobenzaldehyde, o-nitrobenzaldehyde, m-nitrobenzaldehyde, p-nitrobenzaldehyde, o-methylbenzaldehyde, m-methylbenzaldehyde, p-methylbenzaldehyde, p-ethylbenzaldehyde, p-n-butylbenzaldehyde, 1-naphthylaldehyde, 2-naphthylaldehyde, anthracenecarboaldehyde, pyrenecarboaldehyde, furfural, methylal, phthalaldehyde, isophthalaldehyde, terephthalaldehyde, naphthalenedicarboaldehyde, anthracenedicarboaldehyde, and pyrenedicarboaldehyde. The aldehyde compound may be used singly or in combination with two or more thereof.

Examples of the solvent to be used in the polycondensation reaction include: alcohols such as methanol, ethanol, isopropylalcohol, butanol, ethylene glycol, propylene glycol, diethylene glycol, glycerol, methyl cellosolve, ethyl cellosolve, butyl cellosolve, and propylene glycol monomethyl ether; ethers such as diethyl ether, dibutyl ether, diethylene glycol diethyl ether, diethylene glycol dimethyl ether, tetrahydrofurane (THF), and 1,4-dioxane; chlorine solvents such as methylene chloride, chloroform, dichloroethane, and trichloroethylene; hydrocarbons such as hexane, heptane, benzene, toluene, xylene, and cumene; nitriles such as acetonitrile; ketones such as acetone, ethyl methyl ketone, and isobutyl methyl ketone; esters such as ethyl acetate, n-butyl acetate, and propylene glycol methyl ether acetate; lactones such as γ-butyrolactone; and non-proton polar solvents such as dimethylsulfoxide, N,N-dimethylformamide, and hexamethylphosphoric triamide. The solvents may be used singly or in combination with two or more thereof. The solvents can be used in a range of preferably 0 to 2,000 parts by mass, more preferably 10 to 2,000 parts by mass, based on a total of 100 parts by

mass of the naphthol or a derivative thereof and the aldehyde compound.

Examples of the acid catalyst to be used in the polycondensation reaction include: inorganic acids such as hydrochloric acid, hydrobromic acid, sulfuric acid, nitric acid, phosphoric acid, and heteropolyacid; organic acids such as oxalic acid, trifluoroacetic acid, methane sulfonic acid, benzene sulfonic acid, p-toluene sulfonic acid, and trifluoromethane sulfonic acid; and Lewis acids such as aluminum trichloride, aluminum ethoxide, aluminum isopropoxide, boron trifluoride, boron trichloride, boron tribromide, tin tetrachloride, tin tetrabromide, dibutyltin dichloride, dibutyltin dimethoxide, dibutyltin oxide, titanium tetrachloride, titanium tetrabromide, titanium(IV) methoxide, titanium(IV) ethoxide, titanium(IV) isopropoxide, and titanium(IV) oxide.

Examples of the base catalyst to be used in the polycondensation reaction include: inorganic bases such as sodium hydroxide, potassium hydroxide, barium hydroxide, sodium carbonate, sodium bicarbonate, potassium carbonate, lithium hydride, sodium hydride, potassium hydride, and calcium hydride; alkyl metals such as methyl lithium, n-butyl lithium, methyl magnesium chloride, and ethyl magnesium bromide; alkoxides such as sodium methoxide, sodium ethoxide, and potassium tert-butoxide; and organic bases such as triethylamine, diisopropylethylamine, N,N-dimethylaniline, pyridine, and 4-dimethylaminopyridine.

The amount of the catalyst used is preferably in a range of 0.001 to 100 parts by mass, more preferably 0.005 to 50 parts by mass, based on 100 parts by mass of the total of naphthol or a derivative thereof and the aldehyde compound. The reaction temperature is preferably from -50°C to about the boiling point of the solvent, and more preferably from room temperature to 100°C.

Examples of the polycondensation reaction method include a method of collectively preparing naphthol or a derivative thereof, the aldehydes, and the catalyst, and a method of adding naphthol or a derivative thereof, and the aldehydes dropwise in the presence of the catalyst.

The use ratio between naphthol or a derivative thereof and the aldehyde compound is, in a molar ratio of the aldehyde compound to the total of naphthol or a derivative thereof, preferably 0.01 to 5, more preferably 0.05 to 2, still more preferably 0.05 to 1, and most preferably 0.1 to 0.9.

In order to remove the unreacted raw material, the catalyst, and the like remaining in the system after the completion of polycondensation reaction, the temperature of a reaction tank may be increased to 130°C to 230°C and the evaporated substance is removed at about 1 to 50 mmHg, the polymer may be fractionated by adding appropriate solvent or water, or the polymer may be dissolved in a good solvent and then deposited again in a poor solvent. These methods can be selected depending on the property of the resulting reaction product.

The weight average molecular weight (Mw) of the resin I is preferably from 500 to 500,000, more preferably from 1,000 to 100,000. The degree of dispersion (Mw/Mn, Mn: number average molecular weight) of the polymer is preferably in the range of 1.2 to 20, more preferably 1 to 10; if the monomer component, the oligomer component, or the low-molecular weight component with an Mw of less than 500 is cut, the volatile component during the baking can be suppressed and the contamination around a baking cup or the occurrence of a defect on the surface due to the dropping of the evaporation component can be prevented. In the present invention, Mw and Mn are the measured values in terms of polystyrene obtained by gel permeation chromatography (GPC) using THF as the solvent.

The resin composition I preferably includes a crosslinker that crosslinks the resin I through thermal reaction. As the crosslinker, an epoxy compound having two or more functional groups in the molecule, an epoxy resin, an amino resin such as methylol melamine, and the like are suitably used, and a catalyst is preferably added further to accelerate the crosslinking reaction between the crosslinker and the polymer.

Examples of the epoxy compound or the epoxy resin include bi-, tri-, tetra- or higher polyfunctional epoxy resins, such as EOCN-1020 (see the formula below), EOCN-102S, XD-1000, NC-2000-L, EPPN-201, GAN, and NC6000, all manufactured by Nippon Kayaku Co., Ltd., and compounds represented by the following formulae.

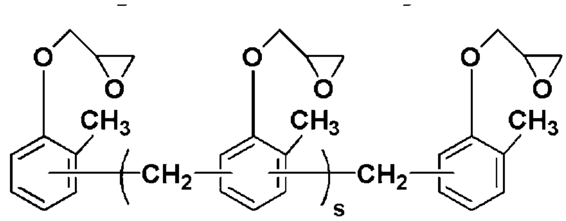

s = 3 to 6

EOCN-1020

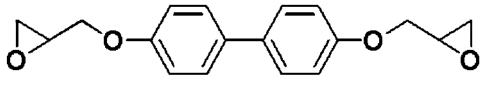

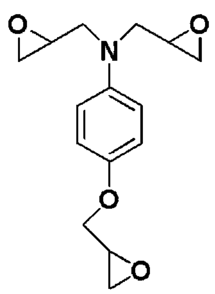

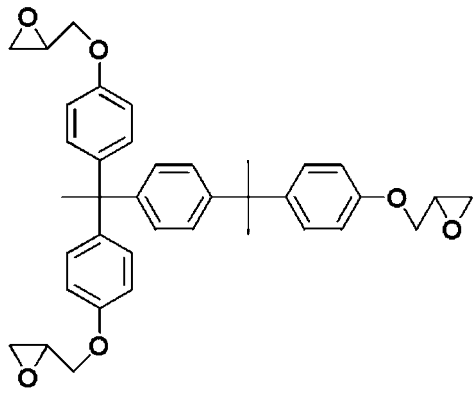

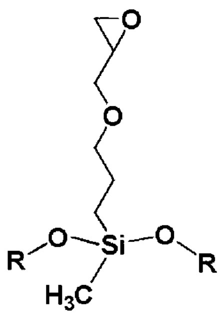

R = methyl group or ethyl group

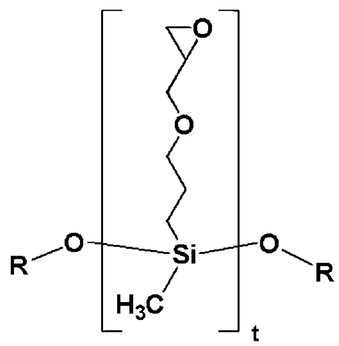

R = methyl group or ethyl group
t = 1 20 wt%
t = 2 75 wt%
t ≥ 3 5 wt%

In the case of using the epoxy compound or the epoxy resin as the crosslinker, the formulation amount thereof is preferably from 0.1 to 50 parts by mass, more preferably from 0.1 to 30 parts by mass, still more preferably from 1 to 30 parts by mass, based on 100 parts by mass of the polymer having a repeating unit represented by formula (1). The crosslinker may be used singly or in combination with two or more thereof. If the formulation amount is within the above range, a sufficient crosslinking density can be obtained, allowing the resulting cured product to function sufficiently.

It should be noted that when the epoxy resin is used as the crosslinker, a curing accelerator is preferably added as a catalyst. The inclusion of the epoxy resin curing accelerator enables the curing reaction to proceed suitably and uniformly.

Examples of the epoxy resin curing accelerator include: imidazole compounds such as 2-methylimidazole, 2-ethyl imidazole, 2-ethyl-4-methyl imidazole, an ethyl isocyanate compound of these compounds, 2-phenyl imidazole, 2-phenyl-4-methyl imidazole, 2-phenyl-4-methyl-5-hydroxymethyl imidazole, and 2-phenyl-4,5-dihydroxymethyl imidazole; DBU compounds such as 1,8-diazabicyclo[5.4.0]undecene-7 (DBU), 1,5-diazabicyclo[4.3.0]nonene-5 (DBN), an organic acid salt of DBU, a phenolic resin salt of DBU, and a tetraphenylborate salt of a DBU derivative; triorganophosphines such as triphenylphosphine, tributyl phosphine, tris(p-methylphenyl)phosphine, tris (p-methoxyphenyl) phosphine, tris(p-ethoxyphenyl)phosphine, triphenylphosphine-triphenylborate, and tetraphenylphosphine-tetraphenylborate; and quaternary phosphonium salt, tertiary amines such as triethylene ammonium-triphenylborate, and tetraphenylboric acid salt thereof. The epoxy resin curing accelerator can be used singly or in combination with two or more thereof.

The formulation amount of the epoxy resin curing accelerator is preferably from 0.1 to 10 parts by mass, more preferably from 0.2 to 5 parts by mass, based on 100 parts by mass of the resin I.

Examples of the amino resin such as methylol melamine for use in the present invention include one or more compounds selected from the group consisting of amino condensates modified with formalin or formalin-alcohol and phenol compounds having two or more methylol groups or alkoxy methylol groups on average per molecule.

The amino resin has a weight average molecular weight Mw of preferably 150 to 10,000, more preferably 200 to 3,000. If the Mw is within the above range, sufficient curability is achieved so that the cured composition has high heat resistance.

Examples of the amino condensates modified with formalin or formalin-alcohol include melamine condensates modified with formalin or formalin-alcohol and urea condensates modified with formalin or formalin-alcohol.

The melamine condensate modified with formalin or formalin-alcohol can be prepared by, for example, modifying

a melamine monomer with formalin into methylol according to a known method or modifying this product further into alkoxy with alcohol to form a modified melamine represented by the following formula. It should be noted that the alcohol is preferably a lower alcohol, for example, an alcohol having 1 to 4 carbon atoms.

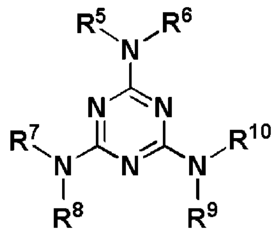

wherein, $R^5$ to $R^{10}$ are each independently a methylol group, an alkoxymethyl group containing a linear, branched, or cyclic alkoxy group having 1 to 4 carbon atoms, or a hydrogen atom, at least one of which is a methylol group or an alkoxymethyl group.

Examples of the modified melamine include trimethoxymethyl monomethylol melamine, dimethoxymethyl monomethylol melamine, trimethylol melamine, hexamethylol melamine, and hexamethoxymethylol melamine. Then, the modified melamine or a multimer thereof (e.g., an oligomer such as a dimer or a trimer) is subjected to addition polycondensation with formaldehyde according to a conventional method until a desired molecular weight is reached, thereby obtaining a melamine condensate modified with formalin or formalin-alcohol. It should be noted that at least one modified melamine condensate selected from the modified melamine and a condensate thereof can be used as a crosslinker.

The urea condensate modified with formalin or formalin-alcohol can be prepared by, for example, modifying a urea condensate having a desired molecular weight with formalin into methylol according to a known method or modifying this product further into alkoxy with alcohol.

Specific examples of the modified urea condensate include a methoxy methylated urea condensate, an ethoxy methylated urea condensate, and a propoxy methylated urea condensate. It should be noted that one or more of these modified urea condensates can be used.

Among these, examples of the phenol compound having, on average, two or more methylol groups or alkoxy methylol groups per molecule include (2-hydroxy-5-methyl)-1,3-benzenedimethanol and 2,2',6,6'-tetramethoxymethylbisphenol A.

These amino condensates or phenol compounds may be used singly or in combination with two or more thereof.

The formulation amount of the crosslinker is preferably from 0.1 to 50 parts by mass, more preferably from 1 to 30 parts by mass, based on 100 parts by mass of the resin I. In this range, the composition I is cured enough, allowing the resulting cured product to function sufficiently.

It should be noted that when the amino resin such as methylol melamine is used as the crosslinker, it is preferable to add a heat acid generator as the catalyst. Examples of this heat acid generator include, but are not particularly limited to, an ammonium salt represented by the following formula:

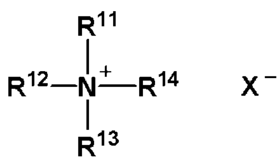

wherein $R^{11}$ to $R^{14}$ each independently represent a hydrogen atom, a linear, branched, or cyclic alkyl group or oxoalkyl group having 1 to 12 carbon atoms, a linear, branched, or cyclic alkenyl group or oxoalkenyl group having 2 to 12 carbon atoms, an aryl group having 6 to 20 carbon atoms, or an aralkyl group or an aryloxoalkyl group having 7 to 12 carbon atoms, and some or all of the hydrogen atoms of these groups may be substituted with alkoxy groups; two selected from $R^{11}$ to $R^{14}$ may form a ring together with a nitrogen atom bonded thereto, the ring being an aliphatic ring having 3 to 10 carbon atoms with the nitrogen atom in the formula in the ring, or a heteroaromatic ring having 5 to 10 carbon atoms with the nitrogen atom in the formula in the ring; and $X^-$ is a sulfonic acid, perfluoroalkyl imide acid, or perfluoroalkyl methide acid in which at least one of $\alpha$-positions is fluorinated.

Specific examples of $X^-$ include: perfluoroalkane sulfonic acid anions such as triflate anion and nonaflate anion; sulfonate anions with at least one of $\alpha$-positions fluoro-substituted; imide anions such as bis(trifluoromethylsulfonyl)imide anion, bis(perfluoroethylsulfonyl)imide anion, and bis(perfluorobutylsulfonyl)imide anion; and methanide anions such as tris(trifluoromethylsulfonyl)methanide anion and tris (perfluoroethylsulfonyl)methanide anion.

The formulation amount of the heat acid generator is preferably from 0.1 to 15 parts by mass, more preferably from 0.2 to 10 parts by mass, based on 100 parts by mass of the resin I. In this range, the composition I is cured enough, and the storage stability of the composition I is also high.

The laser release agent (laser release composition) may contain a solvent. Examples of the solvent include: ketones such as cyclohexanone, cyclopentanone, and methyl-2-n-amyl ketone; alcohols such as 3-methoxy butanol, 3-methyl-3-methoxy butanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, 3-methoxy methyl propionate, 3-ethoxy ethyl propionate, tert-butyl acetate, tert-butyl propionate, propylene glycol mono-tert-butyl ether acetate, and γ-butyrolactone. These solvents may be used singly or in combination with two or more thereof. The formulation amount of the solvent is preferably from 100 to 5,000 parts by mass, more preferably from 150 to 2,500 parts by mass, based on 100 parts by mass of the resin I.

The laser release agent (laser release composition) may contain, for example, a surfactant or an antioxidant for enhancing the heat resistance, if necessary.

Examples of the surfactant include, but are not particularly limited to, nonion-based surfactants, such as polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octyl phenyl ether and polyoxyethylene nonylphenyl ether; polyoxyethylene polyoxypropylene block copolymers; sorbitan fatty acid esters such as sorbitan monolaurate, sorbitan monopalmitate, and sorbitan monostearate; polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, and the like; fluorochemical surfactants such as EFTOP (R) EF301, EF303, and EF352 (manufactured by Tochem Products Co., Ltd.), Megaface (R) F171, F172, and F173 (manufactured by DIC Corporation), Fluorad (R) FC430 and FC431 (manufactured by 3M), AsahiGuard AG710, Surflon (R) S-381, S-382, SC101, SC102, SC103, SC104, SC105, and SC106, and Surfynol (R) E1004, KH-10, KH-20, KH-30, and KH-40 (AGC Inc.); and organosiloxane polymer KP341 (manufactured by Shin-Etsu Chemical Co., Ltd.); and acrylic acid or methacrylic acid polyflow No. 75 and No. 95 (Kyoeisha Chemical Co., Ltd.). These surfactants may be used singly or in combination with two or more thereof.

The antioxidant is preferably at least one selected from the group consisting of a hindered phenol compound, a hindered amine compound, an organic phosphorous compound, and an organic sulfur compound, particularly preferably a hindered phenol compound.

Preferred examples of the hindered phenol compound include, but are not particularly limited to, the following compounds: 1,3,5-trimethyl-2,4,6-tris(3,5-di-tert-butyl-4-hydroxy-benzyl)benzene (product name: IRGANOX 1330); 2,6-di-tert-butyl-4-methylphenol (product name: Sumilizer BHT); 2,5-di-tert-butyl-hydroquinone (product name: Nocrac NS-7); 2,6-di-tert-butyl-4-ethylphenol (product name: Nocrac M-17); 2,5-di-tert-amylhydroquinone (product name: Nocrac DAH); 2,2'-methylenebis(4-methyl-6-tert-butylphenol) (product name: Nocrac NS-6); 3,5-di-tert-butyl-4-hydroxybenzylphosphonate-diethylester (product name: IRGANOX 1222); 4,4'-thiobis(3-methyl-6-tert-butylphenol) (product name: Nocrac 300); 2,2'-methylenebis(4-ethyl-6-tert-butylphenol) (product name: Nocrac NS-5); 4,4'-butylidenebis(3-methyl-6-tert-butylphenol) (product name: ADEKA STAB AO-40); 2-tert-butyl-6-(3-tert-butyl-2-hydroxy-5-methylbenzyl)-4-methylphenylacrylate (product name: Sumilizer GM); 2-[1-(2-hydroxy-3,5-di-tert-pentylphenyl)ethyl]-4,6-di-tert-pentylphenylacrylate (product name: Sumilizer GS); 2,2'-methylenebis[4-methyl-6-(α-methyl-cyclohexyl)phenol]; 4,4'-methylenebis(2,6-di-tert-butylphenol (product name: SEENOX 226M); 4,6-bis(octylthiomethyl)-o-cresol (product name: IRGANOX 1520L); 2,2'-ethylenebis(4,6-di-tertbutylphenol); octadecyl-3-(3,5-di-tert-butyl-4-hydroxyphenyl) -propionate (product name: IRGANOX 1076); 1,1,3-tris(2-methyl-4-hydroxy-5-tert-butylphenyl)butane (product name: ADEKA STAB AO-30); tetrakis[methylene-(3,5-di-tert-butyl-4-hydroxyhydrocinnamate)]methane (product name: ADEKA STAB AO-60); triethyleneglycolbis[3-(3-tert-butyl-5-methyl-4-hydroxyphenyl) propionate] (product name: IRGANOX 245); 2,4-bis(n-octylthio)-6-(4-hydroxy-3,5-di-tert-butylanilino)-1,3,5-triazine (product name: IRGANOX 565); N,N'-hexamethylenebis(3,5-di-tert-butyl-4-hydroxyhydrocinnamamide) (product name: IRGANOX 1098); 1,6-hexanediol-bis[3-(3,5-di-tert-butyl-4-hydroxyphenyl) propionate] (product name: IRGANOX 259); 2,2-thio-diethylene-bis[3-(3,5-di-tert-butyl-4-hydroxyphenyl) propionate] (product name: IRGANOX 1035); 3,9-bis[2-[3-(3-tert-butyl-4-hydroxy-5-methylphenyl)propionyloxy]1,1-dimethylethyl]-2,4,8,10-tetraoxaspiro[5.5]undecane (product name: Sumilizer GA-80); tris-(3,5-di-tert-butyl-4-hydroxybenzyl)isocyanurate (product name: IRGANOX 3114); bis(3,5-di-tert-butyl-4-hydroxybenzylphosphonic acid ethyl) calcium/polyethylene wax mixture (50:50) (product name: IRGANOX 1425WL); isooctyl-3-(3,5-di-tert-butyl-4-hydroxyphenyl)-propionate (product name: IRGANOX 1135); 4,4'-thiobis(6-tert-butyl-3-methylphenol) (product name: Sumilizer WX-R); and 6-[3-(3-tert-butyl-4-hydroxy-5-methylphenyl)-propoxy]-2,4,8,10-tetra-tert-butyldibenz[d,f][1,3,2]dioxaphosphepin (product name: Sumilizer GP).

Preferred examples of the hindered amine compound include, but are not particularly limited to, the following compounds: p,p'-dioctyldiphenylamine (product name: IRGANOX 5057); phenyl-α-naphthylamine (product name: Nocrac PA); poly(2,2,4-trimethyl-1,2-dihydroquinoline) (product name: Nocrac 224, 224-S); 6-ethoxy-2,2,4-trimethyl-1,2-dihydroquinoline (product name: Nocrac AW); N,N'-diphenyl-p-phenylene-diamine (product name: Nocrac DP); N,N'-di-β-naphthyl-p-phenylenediamine (product name: Nocrac White); N-phenyl-N'-isopropyl-p-phenylenediamine (product name: Nocrac 810NA); N,N'-diallyl-p-phenylenediamine (product name: Nonflex TP); 4,4'-(α,α-dimethylbenzyl)diphenylamine (product name: Nocrac CD); p,p-toluenesulfonylamino-diphenylamine (product name: Nocrac TD); N-phenyl-N'-(3-methacryloyloxy-2-hydroxypropyl)-p-phenylenediamine (product name: Nocrac G1); N-(1-methylheptyl)-N'-phenyl-p-phenylenediamine (product name: Ozonon 35); N,N'-di-sec-butyl-p-phenylenediamine (product name: Sumilizer BPA); N-phenyl-N'-1,3-dimethylbutyl-p-phenylenediamine (product name: Antigene 6C); alkylated diphenylamine (product name: Sumilizer 9A); succinic acid dimethyl-1-(2-hydroxyethyl)-4-hydroxy-2,2,6,6-tetramethylpiperidine polycondensate (product name: Tinuvin 622LD); poly[[6-(1,1,3,3-tetramethylbutyl)amino-1,3,5-triazine-2,4-diyl][(2,2,6,6-tetramethyl-4-piperidyl)imino]hexamethylene[(2,2,6,6-tetramethyl-4-piperidyl)imino]] (product name: CHIMASSORB 944); N,N'-bis(3-aminopropyl)ethylenediamine-2,4-bis[N-butyl-N-(1,2,2,6,6-pentamethyl-4-piperidyl)-amino]-6-chloro-1,3,5-triazine condensate (product name: CHIMASSORB 119FL); bis(1-octyloxy-2,2,6,6-tetramethyl-4-piperidyl)sebacate (product name: TINUVIN 123); bis(2,2,6,6-tetramethyl-4-piperidyl)sebacate (product name: TINUVIN 770); 2-(3,5-di-tert-butyl-4-hydroxybenzyl)-2-n-butylmalonic acid bis(1,2,2,6,6-pentamethyl-4-piperidyl) (product name: TINUVIN 144); bis(1,2,2,6,6-pentamethyl-4-piperidyl)sebacate (product name: TINUVIN 765); tetrakis(1,2,2,6,6-pentamethyl-4-piperidyl)1,2,3,4-butanetetra-carboxylate (product name: LA-57); tetrakis(2,2,6,6-tetramethyl-4-piperidyl)1,2,3,4-butanetetracarboxylate (product name: LA-52); an esterified product of a mixture of 1,2,3,4-butanetetracarboxylic acid, and 1,2,2,6,6-pentamethyl-4-piperidinol and 1-tridecanol (product name: LA-62); an esterified product of a mixture of 1,2,3,4-butanetetracarboxylic acid, and 2,2,6,6-tetramethyl-4-piperidinol and 1-tridecanol (product name: LA-67); an esterified product of a mixture of 1,2,3,4-butanetetracarboxylic acid, and 1,2,2,6,6-pentamethyl-4-piperidinol and 3,9-bis(2-hydroxy-1,1-dimethylethyl)-2,4,8,10-tetraoxaspiro[5.5]undecane (product name: LA-63P); an esterified product of a mixture of 1,2,3,4-butanetetracarboxylic acid, and 2,2,6,6-tetramethyl-4-piperidinol and 3,9-bis(2-hydroxy-1,1-dimethylethyl)-2,4,8,10-tetraoxaspiro[5.5]undecane (product name: LA-68LD); (2,2,6,6-tetramethylene-4-piperidyl)-2-propylenecarboxylate (product name: ADEKA STAB LA-82); and (1,2,2,6,6-pentamethyl-4-piperidyl)-2-propylenecarboxylate (product name: ADEKA STAB LA-87).

Preferred examples of the organic phosphorus compound include, but are not particularly limited to, the following compounds: bis(2,4-di-tert-butylphenyl)[1,1-biphenyl]-4,4'-diylbisphosphite; 9,10-dihydro-9-oxa-10-phosphaphenanthrene-10-oxide (product name: SANKO-HCA); triethylphosphite (product name: JP302); tri-n-butylphosphite (product name: JP304); triphenylphosphite (product name: ADEKA STAB TPP); diphenylmonooctylphosphite (product name: ADEKA STAB C); tri(p-cresyl)phosphite (product name: Chelex-PC); diphenylmonodecylphosphite (product name: ADEKA STAB 135A); dipheylmono(tridecyl)phosphite (product name: JPM313); tris(2-ethylhexyl)phosphite (product name: JP308); phenyldidecylphosphite (product name: ADEKA STAB 517); tridecylphosphite (product name: ADEKA STAB 3010); tetraphenyl dipropylene glycol diphosphite (product name: JPP100); bis(2,4-di-tert-butylphenyl)pentaerythritol diphosphite (product name: ADEKA STAB PEP-24G); tris (tridecyl) phosphite (product name: JP333E); bis(nonylphenyl)pentaerythritol diphosphite (product name: ADEKA STAB PEP-4C); bis(2,6-di-tert-butyl-4-methylphenyl)pentaerythritol diphosphite (product name: ADEKA STAB PEP-36); bis[2,4-di(1-phenylisopropyl)phenyl]pentaerythritol diphosphite (product name: ADEKA STAB PEP-45); trilauryltrithiophosphite (product name: JPS312); tris(2,4-di-tert-butylphenyl)phosphite (product name: IRGAFOS 168); tris(nonylphenyl)phosphite (product name: ADEKA STAB 1178); distearyl pentaerythritol diphosphite (product name: ADEKA STAB PEP-8); tris(mono, dinonylphenyl) phosphite (product name: ADEKA STAB 329K); trioleylphosphite (product name: Chelex-OL); tristearylphosphite (product name: JP318E); 4,4'-butylidenebis(3-methyl-6-tert-butylphenylditridecyl)phosphite (product name: JPH1200); tetra($C_{12}$-$C_{15}$ mixed alkyl)-4,4'-isopropylidenediphenyldiphosphite (product name: ADEKA STAB 1500); tetra(tridecyl)-4,4'-butylidenebis(3-methyl-6-tert-butylphenol)diphosphite (product name: ADEKA STAB 260); hexa(tridecyl)-1,1,3-tris(2-methyl-5-tert-butyl-4-hydroxyphenyl)butane-triphosphite (product name: ADEKA STAB 522A); hydrogenated bisphenol A phosphite polymer (HBP); tetrakis(2,4-di-tert-butylphenyloxy) 4,4'-biphenylene-di-phosphine (product name: P-EPQ); tetrakis(2,4-di-tert-butyl-5-methylphenyloxy)4,4'-biphenylene-di-phosphine (product name: GSY-101P); 2-[[2,4,8,10-tetrakis(1,1-dimethylethyl)-dibenzo[d,f][1,3,2]dioxaphosphepin-6-ylloxyl-N,N-bis[2-[[2,4,8,10-tetrakis(1,1-dimethylethyl)dibenzo[d,f][1,3,2]dioxaphosphepin-6-yl]oxy]-ethyl]ethanamine (product name: IRGAFOS 12); and 2,2'-methylenebis(4,6-di-tert-butylphenyl)octylphosphite (product name: ADEKA STAB HP-10).

Preferred examples of the organic sulfur compound include, but are not particularly limited to, the following compounds: dilauryl-3,3'-thiodipropionate (product name: Sumilizer TPL-R); dimyristyl-3,3'-thiodipropionate (product name: Sumilizer TPM); distearyl-3,3'-thiodipropionate (product name: Sumilizer TPS); pentaerythritoltetrakis(3-laurylthiopropionate) (product name: Sumilizer TP-D); ditridecyl-3,3'-thiodipropionate (product name: Sumilizer TL); 2-mercaptobenzimidazole (product name: Sumilizer MB); ditridecyl-3,3'-thiodipropionate (product name: ADEKA STAB AO-503A); 1,3,5-tris-β-stearylthiopropionyloxyethylisocyanurate; 3,3'-thiobispropionate didodecylester (product name: IRGANOX PS 800FL); and 3,3'-thiobispropionate diocdecylester (product name: IRGANOX PS 802FL).

Of the antioxidants, tetrakis[methylene-(3,5-di-tert-butyl-4-hydroxyhydrocinnamate)]methane is particularly

preferred. The amount of the antioxidant added is preferably from 0.5 to 5 parts by mass, more preferably from 1 to 3 parts by mass, based on 100 parts by weight of the resin I. In this range, the enough heat resistance effect can be achieved and the compatibility can be obtained. It should be noted that the antioxidants may be used singly or in combination with two or more thereof.

When the resin composition I is a solution, the resin composition I is applied to a support by such a method as spin coating, roll coating, die coating, printing, or dipping, then prebaking is performed at a temperature of preferably 80°C to 200°C, more preferably 100°C to 180°C, according to volatilization conditions of the solvent, to volatilize the solvent, whereby a resin composition layer I' is formed.

On the other hand, when the resin composition I (laser release layer) is a film-shaped composition, a resin composition layer I' can be formed on a support by a lamination method.

The resin composition layer I' formed on the support functions as the resin layer I (laser release layer) by being further cured by heating. The curing by heating can be carried out using a hot plate or an oven normally under the conditions of 100°C to 350°C for 5 to 10 minutes, preferably 150°C to 300°C for 3 to 8 minutes. The curing reaction can also be achieved by forming a wafer laminate in an uncured state without curing the resin composition layer I', then heating the laminate as a whole.

The film thickness of the resin layer I (laser release layer) formed on the support is preferably from 0.1 to 50 μm, more preferably from 0.3 to 30 μm. If the film thickness is in this range, a sufficient light-shielding property is obtained, and flatness of the film is also good.

[Silicone-Based Resin-Containing Temporary Adhesive]

The silicone-based resin-containing temporary adhesive of the present invention satisfies the specification of the dissolution rate but preferably includes a curable silicone resin containing the following components:

(A) an organopolysiloxane having two or more alkenyl groups per molecule;
(B) an organohydrogenpolysiloxane having two or more silicon atom-bonded hydrogen atoms (Si-H groups) per molecule; and
(C) a platinum-based catalyst.

Here, the composition preferably contains the components in such an amount that a molar ratio of the Si-H groups in the component (B) to the alkenyl groups in the component (A) is from 0.3 to 10.

The silicone-based resin-containing temporary adhesive of the present invention preferably further includes a component (D), and accordingly includes the following components (A) to (D):

(A) 100 parts by mass of an organopolysiloxane having two or more alkenyl groups per molecule;
(B) an organohydrogenpolysiloxane having two or more silicon atom-bonded hydrogen atoms (Si-H groups) per molecule, in such an amount that a molar ratio of the total of SiH groups in the component (B) to the total of alkenyl groups in the component (A) is from 0.3 to 10;
(C) a platinum-based catalyst (hydrosilylation reaction catalyst) in an amount of 0.1 to 5,000 ppm of in terms of metal atom mass based on the total mass of components (A), (B), and (D); and
(D) 0.1 to 200 parts by mass of a non-functional organopolysiloxane.

The silicone-based resin-containing temporary adhesive is a resin used to form a silicone-based resin layer (hereinafter also referred to as "resin layer II").

[Component (A)]

The component (A) is an organopolysiloxane having two or more alkenyl groups per molecule. Examples of the component (A) include a linear or branched diorganopolysiloxane containing two or more alkenyl groups per molecule and an organopolysiloxane of three-dimensional network structure containing two or more alkenyl groups per molecule and siloxane units (Q units) represented by SiO4/2 units. Of these, the diorganopolysiloxane or organopolysiloxane of three-dimensional network structure having an alkenyl group content of 0.6 to 9 mol% is preferred. As used herein, the alkenyl group content refers to a proportion (mol%) of the number of alkenyl groups to the number of silicon atoms in the molecule.

Examples of the organopolysiloxane include polymers having the following formula (A-1), (A-2) or (A-3), which may be used singly or in combination with two or more thereof.

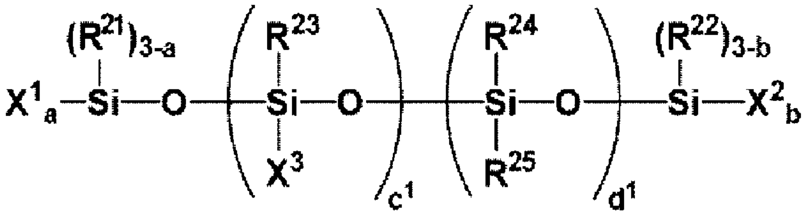

(A-1)

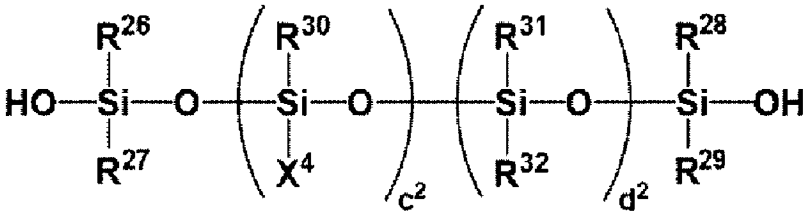

(A-2)

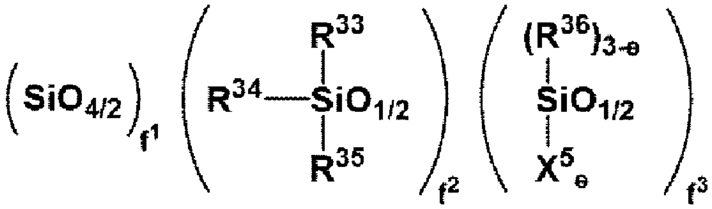

(A-3)

In formulae (A-1) to (A-3), $R^{21}$ to $R^{36}$ are each independently a monovalent hydrocarbon group other than an aliphatic unsaturated hydrocarbon group. $X^1$ to $X^5$ are each independently an alkenyl group-containing monovalent organic group.

In formula (A-1), "a" and "b" are each independently an integer of 0 to 3. In formulae (A-1) and (A-2), "$c^1$", "$c^2$", "$d^1$", and "$d^2$" are integers satisfying $0 \leq c^1 \leq 10$, $2 \leq c^2 \leq 10$, $0 \leq d^1 \leq 100$, and $0 \leq d^2 \leq 100$, provided that $a + b + c^1 \geq 2$. "a", "b", "$c^1$", "$c^2$", "$d^1$", and "$d^2$" are preferably the combination of numbers such that the alkenyl group content is from 0.6 to 9 mol%.

In formula (A-3), "e" is an integer of 1 to 3. "$f^1$", "$f^2$", and "$f^3$" are such numbers that $(f^2 + f^3)/f^1$ is from 0.3 to 3.0 and $f^3/(f^1 + f^2 + f^3)$ is from 0.01 to 0.6.

The monovalent hydrocarbon group other than the aliphatic unsaturated hydrocarbon group preferably has 1 to 10 carbon atoms, and examples thereof include alkyl groups such as a methyl group, an ethyl group, an n-propyl group, an isopropyl group, an n-butyl group, a tert-butyl group, an n-pentyl group, and an n-hexyl group; cycloalkyl groups such as a cyclopentyl group and a cyclohexyl group; and aryl groups such as a phenyl group and a tolyl group. Of these groups, an alkyl group such as a methyl group or a phenyl group is preferred.

The alkenyl group-containing monovalent organic group preferably has 2 to 10 carbon atoms, and examples thereof include alkenyl groups such as a vinyl group, an allyl group, a hexenyl group, and an octenyl group; (meth)acryloyl alkyl groups such as an acryloyl propyl group, an acryloyl methyl group, and a methacryloyl propyl group; (meth)acryloxy alkyl groups such as an acryloxy propyl group, an acryloxy methyl group, a methacryloxy propyl group, and a methacryloxy methyl group; and alkenyl group-containing monovalent hydrocarbon groups such as a cyclohexenyl ethyl group and a vinyloxy propyl group. Of these groups, a vinyl group is preferred from the industrial point of view.

In formula (A-1), "a" and "b" are each independently an integer of 0 to 3. It is preferable that "a" be from 1 to 3 because a molecular chain end is capped with an alkenyl group, which is highly reactive and thus allows the reaction to be completed in a short time with a highly reactive alkenyl group at the molecular chain end. From the economy aspect, it is industrially preferable that "a" be 1. The alkenyl group-containing diorganopolysiloxane represented by formula (A-1) or (A-2) is preferably in the form of oil or raw rubber.

The organopolysiloxane represented by formula (A-3) has three-dimensional network structure and contains $SiO_{4/2}$ units. In formula (A-3), "e" is each independently an integer of 1 to 3. From the economy aspect, it is industrially preferable that "e" be 1. In addition, the average value of e multiplied by $f^3/(f1 + f2 + f3)$ is from 0.02 to 1.5, more preferably from 0.03 to 1.0. The organopolysiloxane represented by formula (A-3) may be used as a solution dissolved in an organic solvent.

The organopolysiloxane serving as the component (A) preferably has a number average molecular weight (Mn) of 100 to 1,000,000, more preferably 1,000 to 100,000. If the Mn is in this range, the composition is satisfactory in working in terms of viscosity and processing in terms of storage elastic modulus after curing. As used herein, Mn is a measured value in terms of polystyrene determined by gel permeation chromatography using a toluene as a solvent.

The component (A) may be used singly or in combination with two or more thereof. Especially, an organopolysiloxane represented by formula (A-1) and an organopolysiloxane represented by formula (A-3) are preferably used in combination. At this point, the amount of the organopolysiloxane represented by formula (A-3) used is preferably from 1 to 1,000 parts by mass, more preferably from 10 to 500 parts by mass, based on 100 parts by mass of the organopolysiloxane represented by formula (A-1).

[Component (B)]

The component (B), which serves as a crosslinker, is an organohydrogenpolysiloxane having at least two, preferably three or more silicon atom-bonded hydrogen atoms (SiH groups) per molecule. The organohydrogenpolysiloxane may be any of linear, branched, or cyclic, and may be used singly or in combination with two or more thereof.

The organohydrogenpolysiloxane serving as the component (B) has a viscosity at 25°C of preferably 1 to 5,000 mPa·s, more preferably 5 to 500 mPa·s. As used herein, the viscosity is a measured value at 25°C with a rotational viscometer. The Mn of the component B is also measured by GPC in the same manner as the component A.

The organohydrogenpolysiloxane serving as the component (B) has a Mn of preferably 100 to 100,000, more preferably 500 to 10,000. If the Mn is in this range, the composition is satisfactory in working in terms of viscosity and processing in terms of storage elastic modulus after curing.

The component (B) is blended in such an amount that a molar ratio (SiH groups/alkenyl groups) of the total of SiH groups in the component (B) to the total of alkenyl groups in the component (A) is preferably from 0.3 to 10, more preferably from 1.0 to 8.0. As long as the molar ratio is 0.3 or more, the problems such as a reduction in the crosslinking density and failure to cure a temporary adhesive agent layer (silicone-based resin layer) do not arise. Furthermore, as long as the molar ratio is 10 or less, the crosslinking density does not become excessively high, a satisfactory pressure-sensitive adhesive force and tack are obtained, allowing for an extended usable time of a treating solution.

[Component (C)]

The component (C) functions as a hydrosilylation reaction catalyst, preferably a platinum group metal-based hydrosilylation reaction catalyst to be used, and more preferably a platinum-based catalyst as described above. The component (C) serves as a catalyst that promotes the addition reaction between the alkenyl groups in the component (A) and hydrosilyl groups in the component (B). Since the hydrosilylation reaction catalyst is generally a compound of a noble metal and is expensive, a platinum or a platinum compound, which is relatively easily available, is often used.

Examples of the platinum compound include chloroplatinic acid, a complex of chloroplatinic acid and an olefin such as ethylene, a complex of chloroplatinic acid and an alcohol or vinylsiloxane, and metallic platinum supported on silica, alumina, carbon, or the like. As platinum group metal catalysts other than the platinum compound, rhodium-based, ruthenium-based, iridium-based, and palladium-based compounds are also known, and examples thereof include $RhCl(PPh_3)_3$, $RhCl(CO)(PPh_3)_2$, $Ru_3(CO)_{12}$, $IrCl(CO)(PPh_3)_2$, and $Pd(PPh_3)_4$. It should be noted that in the formula, "Ph" represents a phenyl group.

These catalysts, which are often solid, may be used in the solid form. However, a solution of chloroplatinic acid or a complex thereof in a suitable solvent is preferably used because the solution is compatible with the compound (A) so that a cured product becomes more uniform.

The amount of component (C) added is an effective amount, and is generally from 0.1 to 5,000 ppm of in terms of metal atom mass based on the total mass of components (A), (B), and (D), preferably from 1 to 1,000 ppm. When the amount is 0.1 ppm or more, the curability of the composition does not deteriorate, or the crosslinking density and the retention strength do not decrease. When the amount is 5,000 ppm or less, side reactions such as dehydrogenation during curing can be suppressed, allowing for an extended usable time of a treating solution.

[Component (D)]

The component (D) is a non-functional organopolysiloxane. As used herein, "non-functional" means that the molecule does not contain a reactive group such as a hydrogen atom, a halogen atom, a hydroxy group, or an alkoxy group directly bonded to a silicon atom, nor does it contain a reactive group such as an alkenyl group or an epoxy group bonded directly or via any substituent to a silicon atom.

Examples of such a non-functional organopolysiloxane include an organopolysiloxane containing an unsubstituted or substituted monovalent hydrocarbon group having 1 to 12 carbon atoms, preferably 1 to 10 carbon atoms, other than an aliphatic unsaturated hydrocarbon group. Examples of such a monovalent hydrocarbon group include alkyl groups such as a methyl group, an ethyl group, a propyl group, a butyl group, a pentyl group, a hexyl group, and a heptyl group; cycloalkyl groups such as a cyclohexyl group; aryl groups such as a phenyl group, a tolyl group, a xylyl group, and a naphthyl group; and aralkyl groups such as a benzyl group and a phenethyl group. Some or all of the hydrogen atoms in these groups may be substituted with halogen atoms such as a chlorine atom, a fluorine atom, and a bromine atom, and

examples of such groups include halogenated alkyl groups such as a chloromethyl group, a 3-chloropropyl group, and a 3,3,3-trifluoropropyl group. The monovalent hydrocarbon group is preferably an alkyl group or an aryl group, and more preferably a methyl group or a phenyl group.

The molecular structure of the component (D), which is a non-functional organopolysiloxane, is not particularly limited and may be any of linear, branched, cyclic, and the like, but a linear or branched organopolysiloxane is preferable. In particular, a linear or branched diorganopolysiloxane in which the main chain is basically composed of repeating dioragnosiloxane units and the molecular chain ends are capped with triorganosiloxy groups is preferable.

The non-functional organopolysiloxane of the component (D) preferably has a viscosity of 100 to 500,000 mPa·s, more preferably 200 to 100,000 mPa·s, at 25°C in a 30% by mass toluene solution, from the viewpoint of workability of the composition, coatability onto a substrate, mechanical properties of the cured product, and peelability from the support. Within this range, the molecular weight is appropriate, and therefore, the organopolysiloxane does not volatilize during curing by heating of the silicone resin composition, which would otherwise reduce the effects, nor does it cause wafer cracking during wafer thermal processes such as CVD, thus exhibiting favorable workability and coatability. It should be noted that the viscosity of the component D is measured using a rotational viscometer at 25°C.

Examples of the linear non-functional organopolysiloxane include a dimethylsiloxane polymer having both molecular chain ends capped with trimethylsiloxy groups, a diphenylpolysiloxane having both molecular chain ends capped with trimethylsiloxy groups, a 3,3,3-trifluoropropylmethylsiloxane polymer having both molecular chain ends capped with trimethylsiloxy groups, a dimethylsiloxane/diphenylsiloxane copolymer having both molecular chain ends capped with trimethylsiloxy groups, a dimethylsiloxane/3,3,3-trifluoropropylmethyl copolymer having both molecular chain ends capped with trimethylsiloxy groups, a diphenylsiloxane/3,3,3-trifluoropropylmethyl copolymer having both molecular chain ends capped with trimethylsiloxy groups, a dimethylsiloxane/3,3,3-trifluoropropylmethylsiloxane/diphenylsiloxane copolymer having both molecular chain ends capped with trimethylsiloxy groups, a dimethylpolysiloxane having both molecular chain ends capped with triphenylsiloxy groups, a diphenylpolysiloxane having both molecular chain ends capped with triphenylsiloxy groups, and a dimethylsiloxane/diphenylsiloxane copolymer having both molecular chain ends capped with triphenylsiloxy groups.

Examples of the branched non-functional organopolysiloxane include, the following compounds:

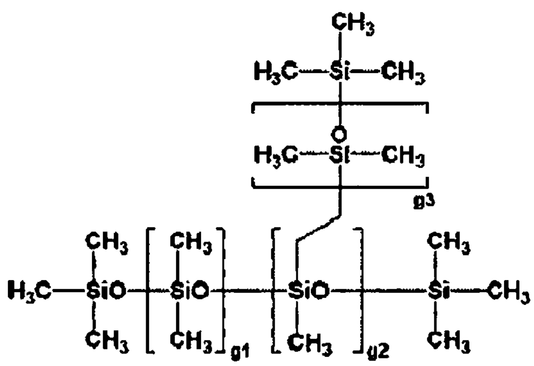

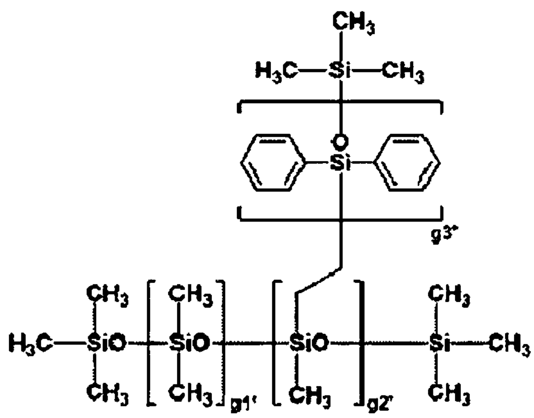

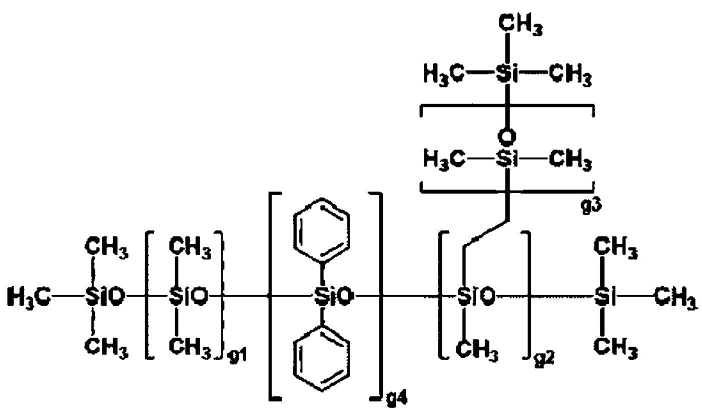

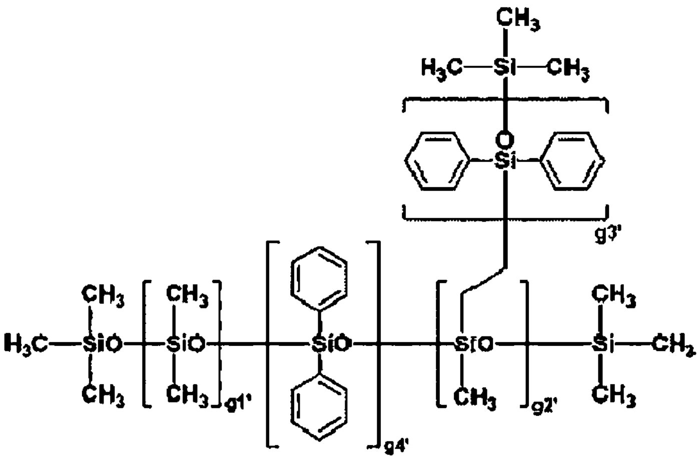

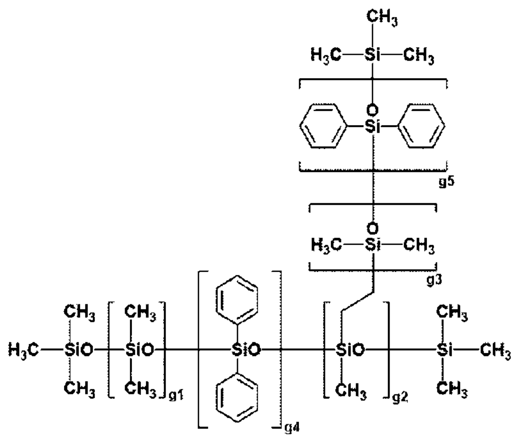

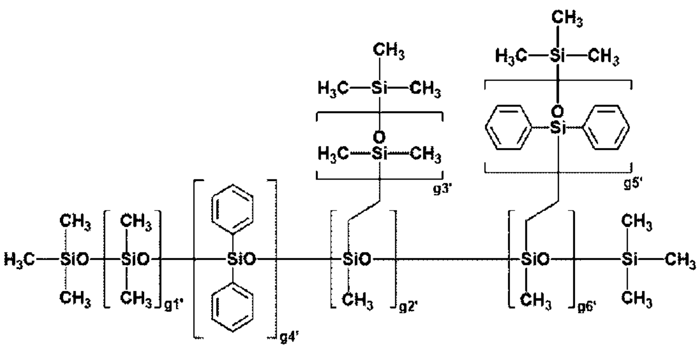

wherein g1, g2, g3, g4, g5, g1', g2', g3', g4', g5', and g6' are each independently an arbitrary integer such that the viscosity at 25°C of a 30% by mass toluene solution of the compound falls within the above range.

The formulation amount of the component (D), which is a non-functional organopolysiloxane, is 0.1 to 200 parts by mass, preferably 1 to 180 parts by mass, and more preferably 10 to 170 parts by mass, based on 100 parts by mass of the component (A). When the formulation amount of the component (D) is within the above range, the wafer can be easily peeled off from the support. The component (D), which is a non-functional organopolysiloxane, may be used singly or in combination with two or more thereof, and is preferably in the form of oil or raw rubber.

Furthermore, in the present invention, the proportion of the dimethylsiloxane unit in the nonvolatile component of the silicone-based resin-containing temporary adhesive is preferably 20% by mass or more by adjusting the formulation amount of the non-functional organopolysiloxane of the component (D). The upper limit is not particularly limited, but is about 95% by mass. Such a proportion of dimethylsiloxane units can further increase the dissolution rate of the temporary adhesive layer formed of the temporary adhesive. The dissolution rate is 20 μm/min or more. The upper limit is not particularly limited, but is about 200 μm/min or less, preferably at least 50 μm/min or more.

[Component (E)]

A thermosetting silicone resin composition may further contain, as the component (E), a reaction control agent. The reaction control agent is optionally added, if needed, during preparation of the composition or application to a substrate, in order to prevent thickening or gelation of the composition.

Examples of the reaction control agent include 3-methyl-1-butin-3-ol, 3-methyl-1-pentin-3-ol, 3,5-dimethyl-1-hexyn-3-ol, 1-ethynylcyclohexanol, 3-methyl-3-trimethylsiloxy-1-butin, 3-methyl-3-trimethylsiloxy-1-pentin, 3,5-dimethyl-3-trimethylsiloxy-1-hexyn, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Of these, 1-ethynylcyclohexanol and 3-methyl-1-butin-3-ol are preferred.

When the thermosetting silicone resin composition contains component (E), the content thereof should be adjusted to the optimal amount according to the difference of the control capability determined by its chemical structure. In consideration of curability, storage stability, and post-curing physical properties, the content of the component (E) is preferably from 0.001 to 10 parts by mass, more preferably from 0.01 to 10 parts by mass, based on 100 parts by mass of the total of components (A), (B), and (D). Within this range, the composition exhibits a long usable time, excellent long-term storage stability, favorable curability, and good workability.

The thermosetting silicone resin composition may further contain an organopolysiloxane including $R^A{}_3SiO_{0.5}$ units (wherein $R^A$ is each independently an unsubstituted or substituted monovalent hydrocarbon group having 1 to 10 carbon atoms) and SiO2 units, with a molar ratio ($R^A{}_3SiO_{0.5}/SiO_2$) of the RA3SiO0.5 units to the SiO2 units being from 0.3 to 1.8. The amount of such organopolysiloxane added is preferably from 0 to 500 parts by mass based on 100 parts by mass of the component (A).

Preferably, the silicone-based resin-containing temporary adhesive of the present invention includes a heat resistance enhancer. The heat resistance enhancer is preferably at least one compound selected from hindered phenol compounds and hindered amine compounds.

Preferred examples of the hindered phenol compound include, but are not particularly limited to, the following compounds: 1,3,5-trimethyl-2,4,6-tris(3,5-di-tert-butyl-4-hydroxy-benzyl)benzene (product name: IRGANOX 1330); 2,6-di-tert-butyl-4-methylphenol (product name: Sumilizer BHT); 2,5-di-tert-butyl-hydroquinone (product name: Nocrac NS-7); 2,6-di-tert-butyl-4-ethylphenol (product name: Nocrac M-17); 2,5-di-tert-amylhydroquinone (product name: Nocrac DAH); 2,2'-methylenebis(4-methyl-6-tert-butylphenol) (product name: Nocrac NS-6); 3,5-di-tert-butyl-4-hydroxybenzylphosphonate-diethylester (product name: IRGANOX 1222); 4,4'-thiobis(3-methyl-6-tert-butylphenol) (product name: Nocrac 300); 2,2'-methylenebis(4-ethyl-6-tert-butylphenol) (product name: Nocrac NS-5); 4,4'-butylidenebis(3-methyl-6-tert-butylphenol) (product name: ADEKA STAB AO-40); 2-tert-butyl-6-(3-tert-butyl-2-hydroxy-5-methylbenzyl)-4-methylphenylacrylate (product name: Sumilizer GM); 2-[1-(2-hydroxy-3,5-di-tert-pentylphenyl)ethyl]-4,6-di-tert-pentylphenylacrylate (product name: Sumilizer GS); 2,2'-methylenebis[4-methyl-6-(α-methyl-cyclohexyl)phenol]; 4,4'-methylenebis(2,6-di-tert-butylphenol (product name: SEENOX 226M); 4,6-bis(octylthiomethyl)-o-cresol (product name: IRGANOX 1520L); 2,2'-ethylenebis(4,6-di-tertbutylphenol); octadecyl-3-(3,5-di-tert-butyl-4-hydroxyphenyl) -propionate (product name: IRGANOX 1076); 1,1,3-tris(2-methyl-4-hydroxy-5-tert-butylphenyl)butane (product name: ADEKA STAB AO-30); tetrakis[methylene-(3,5-di-tert-butyl-4-hydroxyhydrocinnamate)]methane (product name: ADEKA STAB AO-60); triethyleneglycolbis[3-(3-tert-butyl-5-methyl-4-hydroxyphenyl) propionate] (product name: IRGANOX 245); 2,4-bis(n-octylthio)-6-(4-hydroxy-3,5-di-tert-butylanilino)-1,3,5-triazine (product name: IRGANOX 565); N,N'-hexamethylenebis(3,5-di-tert-butyl-4-hydroxyhydrocinnamamide) (product name: IRGANOX 1098); 1,6-hexanediol-bis [3-(3,5-di-tert-butyl-4-hydroxyphenyl) propionate] (product name: IRGANOX 259); 2,2-thio-diethylene-bis[3-(3,5-di-tert-butyl-4-hydroxyphenyl) propionate] (product name: IRGANOX 1035); 3,9-bis[2-[3-(3-tert-butyl-4-hydroxy-5-methylphenyl)propionyloxy]1,1-dimethylethyl]-2,4,8,10-tetraoxaspiro[5.5]undecane (product name: Sumilizer GA-80); tris-(3,5-di-tert-butyl-4-hydroxybenzyl)isocyanurate (product name: IRGANOX 3114); bis(3,5-di-tert-butyl-4-hydroxybenzylphosphonic acid ethyl) calcium/polyethylene wax mixture (50:50) (product name: IRGANOX 1425WL); isooctyl-3-(3,5-di-tert-butyl-4-hydroxyphenyl)propionate (product name: IRGANOX 1135); 4,4'-thiobis(6-tert-butyl-3-methylphenol) (product name: Sumilizer WX-R); and 6-[3-(3-tert-butyl-4-hydroxy-5-methylphenyl)propoxy]-2,4,8,10-tetra-tert-butyldibenz[d,f][1,3,2]dioxaphosphepin (product name: Sumilizer GP).

Preferred examples of the hindered amine compound include, but are not particularly limited to, the following compounds: p,p'-dioctyldiphenylamine (product name: IRGANOX 5057); phenyl-α-naphthylamine (product name: Nocrac PA); poly(2,2,4-trimethyl-1,2-dihydroquinoline) (product name: Nocrac 224, 224-S); 6-ethoxy-2,2,4-trimethyl-1,2-dihydroquinoline (product name: Nocrac AW); N,N'-diphenyl-p-phenylene-diamine (product name: Nocrac DP); N,N'-di-β-naphthyl-p-phenylenediamine (product name: Nocrac White); N-phenyl-N'-isopropyl-p-phenylenediamine (product name: Nocrac 810NA); N,N'-diallyl-p-phenylenediamine (product name: Nonflex TP); 4,4'-(α,α-dimethylbenzyl)diphenylamine (product name: Nocrac CD); p,p-toluenesulfonylamino-diphenylamine (product name: Nocrac TD); N-phenyl-N'-(3-methacryloyloxy-2-hydroxypropyl)-p-phenylenediamine (product name: Nocrac G1); N-(1-methylheptyl)-N'-phenyl-p-phenylenediamine (product name: Ozonon 35); N,N'-di-sec-butyl-p-phenylene-diamine (product name: Sumilizer

BPA); N-phenyl-N'-1,3-dimethylbutyl-p-phenylene-diamine (product name: Antigene 6C); alkylated diphenylamine (product name: Sumilizer 9A); succinic acid dimethyl-1-(2-hydroxyethyl)-4-hydroxy-2,2,6,6-tetramethylpiperidine polycondensate (product name: Tinuvin 622LD); poly[[6-(1,1,3,3-tetramethylbutyl)amino-1,3,5-triazine-2,4-diyl][(2,2,6,6-tetramethyl-4-piperidyl)imino]hexamethylene[(2,2,6,6-tetramethyl-4-piperidyl)imino]] (product name: CHIMASSORB 944); N,N'-bis(3-aminopropyl)ethylenediamine-2,4-bis[N-butyl-N-(1,2,2,6,6-pentamethyl-4-piperidyl)-amino]-6-chloro-1,3,5-triazine condensate (product name: CHIMASSORB 119FL); bis(1-octyloxy-2,2,6,6-tetramethyl-4-piperidyl)sebacate (product name: TINUVIN 123); bis(2,2,6,6-tetramethyl-4-piperidyl)sebacate (product name: TINUVIN 770); 2-(3,5-di-tert-butyl-4-hydroxybenzyl)-2-n-butylmalonic acid bis(1,2,2,6,6-pentamethyl-4-piperidyl) (product name: TINUVIN 144); bis(1,2,2,6,6-pentamethyl-4-piperidyl)sebacate (product name: TINUVIN 765); tetrakis(1,2,2,6,6-pentamethyl-4-piperidyl)1,2,3,4-butanetetra-carboxylate (product name: LA-57); tetrakis(2,2,6,6-tetramethyl-4-piperidyl)1,2,3,4-butanetetracarboxylate (product name: LA-52); an esterified product of a mixture of 1,2,3,4-butanetetracarboxylic acid, and 1,2,2,6,6-pentamethyl-4-piperidinol and 1-tridecanol (product name: LA-62); an esterified product of a mixture of 1,2,3,4-butanetetracarboxylic acid, and 2,2,6,6-tetramethyl-4-piperidinol and 1-tridecanol (product name: LA-67); an esterified product of a mixture of 1,2,3,4-butanetetracarboxylic acid, and 1,2,2,6,6-pentamethyl-4-piperidinol and 3,9-bis(2-hydroxy-1,1-dimethylethyl)-2,4,8,10-tetraoxaspiro[5.5]undecane (product name: LA-63P); an esterified product of a mixture of 1,2,3,4-butanetetracarboxylic acid, and 2,2,6,6-tetramethyl-4-piperidinol and 3,9-bis(2-hydroxy-1,1-dimethylethyl)-2,4,8,10-tetraoxaspiro[5.5]undecane (product name: LA-68LD); (2,2,6,6-tetramethylene-4-piperidyl)-2-propylenecarboxylate (product name: ADEKA STAB LA-82); and (1,2,2,6,6-pentamethyl-4-piperidyl)-2-propylenecarboxylate (product name: ADEKA STAB LA-87).

Such a heat resistance enhancer is preferably used in an amount of 0.5 to 10 parts by mass, more preferably 0.5 to 5 parts by mass, and still more preferably 1 to 3 parts by mass, based on 100 parts by mass of the silicone resin. The heat resistance enhancer may be added during synthesis of the resin or during mixing of the resin with other processed materials.

The thermosetting silicone resin composition may further contain a filler such as silica, in order to further enhance the heat resistance of the resulting temporary adhesive agent layer.

The thermosetting silicone resin composition may be used in solution form by adding a solvent, in order to improve workability through viscosity reduction of the composition, enhance miscibility, and adjust the film thickness of the temporary adhesive agent layer. The solvent to be used is not particularly limited as long as it can dissolve the above components. However, preferred examples thereof include hydrocarbon-based solvents such as pentane, hexane, cyclohexane, isooctane, nonane, decane, p-menthane, pinene, isododecane, and limonene.

Methods for solution preparation include: adding a solvent after preparing the thermosetting silicone resin composition to adjust the viscosity to a desired level; or pre-diluting high-viscosity components (A), (B), and/or (D) with a solvent to improve workability and miscibility, followed by mixing with the remaining components. As for mixing methods during solution preparation, appropriate techniques may be selected based on the viscosity and workability of the composition, such as using a shaking mixer, magnetic stirrer, or various types of mechanical mixers.

The formulation amount of the solvent may be appropriately set in view of factors such as the viscosity and workability of the composition and the film thickness adjustment of the temporary adhesive agent layer. For example, the amount is preferably from 5 to 900 parts by mass, and more preferably from 10 to 400 parts by mass, based on 100 parts by mass of the thermosetting silicone resin composition.

The temporary adhesive agent layer can be formed by applying the thermosetting silicone resin composition onto a substrate using methods such as spin coating or roll coating. Among these, when the temporary adhesive agent layer is formed on the substrate by methods such as spin coating, it is preferable to use the thermosetting silicone resin composition in solution form for coating.

The thermosetting silicone resin composition in solution form preferably has a viscosity of 1 to 100,000 mPa·s, more preferably 10 to 10,000 mPa·s at 25°C, from the viewpoint of coatability.

The thermosetting silicone resin composition, after curing, typically exhibits a 180° peel strength of 2 to 50 gf at 25°C using a 25 mm-wide test piece (e.g., a glass test piece), preferably 3 to 30 gf, and more preferably 5 to 20 gf. A peel strength of 2 gf or more prevents wafer separation during grinding, while a peel strength of 50 gf or less facilitates easy wafer peeling.

The thermosetting silicone resin composition, after curing, preferably has a storage modulus at 25°C of 1,000 Pa or more and 1,000 MPa or less, more preferably 10,000 Pa or more and 100 MPa or less. A storage modulus of 1,000 Pa or more ensures that the resulting film is sufficiently robust, thereby preventing wafer separation and cracking during wafer grinding. A storage modulus of 1,000 MPa or less allows deforming stress relaxation during thermal processes of the wafer such as CVD, ensuring stability during such thermal processes of the wafer.

[Method for Processing Circuit Substrate]

Next, a method for processing a circuit substrate using a silicone-based resin-containing temporary adhesive is

described.

The method for processing a circuit substrate of the present invention may include steps of:

(a) providing a laminate comprising a circuit substrate as the semiconductor substrate and the support, which are temporarily adhered to each other via a silicone-based resin layer formed using the silicone-based resin-containing temporary adhesive of the present invention and a laser release layer formed using the laser release agent;
(b) processing a back surface of the laminate;
(c) separating the support from the laminate by laser irradiation from a support side; and
(d) removing the silicone-based resin layer and the laser release layer from the separated laminate using a cleaning solution having a temperature of 40°C to 60°C to take out only the circuit substrate.

[Step (a)]

As described above, Step (a) involves providing a laminate including a circuit substrate and a support as a semiconductor substrate. This step can be performed more specifically as follows, but is not limited thereto.

[Step (a1) or (a1')]

Step (a1) involves forming a resin layer I having a light-shielding property on the support, and step (a1') involves forming a resin composition layer I' on the support. When the resin composition I for forming the resin layer I is a solution, the resin composition I is applied to the support by such a method as spin coating or roll coating, then prebaking is performed at a temperature of preferably 80°C to 200°C, more preferably 100°C to 180°C, according to volatilization conditions of the solvent, to volatilize the solvent, whereby a resin composition layer I' is formed. In addition, when the resin composition I is a film-shaped composition, a resin composition layer I' can be formed on the support by a lamination method.

The resin composition layer I' formed on the support may function as the resin layer I by being cured by heating. The curing by heating can be carried out using a hot plate or an oven normally at a temperature of 100°C to 300°C, preferably 150°C to 300°C. The curing time is normally from 1 to 10 minutes, preferably from 2 to 8 minutes. The curing reaction can also be achieved by forming a wafer laminate in an uncured state without curing the resin composition layer I', then heating the laminate as a whole.

[Step (a2) or (a2')]

Step (a2) involves forming a resin layer II on the circuit-formed surface of a semiconductor substrate (wafer), and step (a2') involves forming a resin layer II on the resin layer I or the resin composition layer I'. When the silicone-based resin-containing temporary adhesive is a solution, the resin layer II can be formed by applying the temporary adhesive on the semiconductor substrate (wafer) by methods such as spin coating, roll coating, die coating, printing, and dipping, and then heating the temporary adhesive at 130°C to 190°C using a hot plate or an oven.

On the other hand, when the silicone-based resin-containing temporary adhesive is a film-shaped composition, a resin layer II can be formed on a wafer by a lamination method.

[Step (a3) or (a3')]

Step (a3) involves bonding the resin layer I or the resin composition I' and the resin layer II under reduced pressure, and step (a3') involves bonding the resin layer II on the support and the circuit-formed surface of the wafer under reduced pressure. The reduced pressure is preferably 0.1 to 100 Pa, and more preferably 1 to 80 Pa. At this time, the substrate is uniformly pressure-bonded and bonded under reduced pressure in a temperature range of preferably 40°C to 240°C, and more preferably 60°C to 220°C.

[Step (a4)]

Step (a4) involves thermally curing the resin composition layer A' of the wafer laminate bonded in step (a3) or (a4') to form the resin layer I and bonding with the resin layer II. After the wafer laminate is formed, thermal curing is performed by heating at 120°C to 260°C, preferably at 150°C to 250°C for 1 minute to 4 hours, preferably 3 minutes to 2 hours.

As described above, a laminate can be provided (step a).

[Step (b)]

Step (b) involves processing a back surface of the laminate. The step is of processing a non-circuit-formed surface of a semiconductor substrate (wafer) obtained by grinding the non-circuit-formed surface of the wafer, that is, processing the non-circuit-formed surface of a wafer thinned by grinding the back surface. Various processes used at the wafer level are included in this step. Examples thereof include wafer surface treatment, electrode formation, metal wiring formation, and protective film formation. Specific examples thereof include conventionally known processes such as CVD for wafer surface treatment, laser annealing, metal sputtering for the formation of electrodes and the like, vapor deposition, wet etching for etching a metal-sputtered layer, pattern formation by coating, exposure, and development of resist for use as a mask for metal wiring formation, resist stripping, dry etching, metal plating formation, organic film formation for surface protection, silicon etching for TSV formation, and oxide film formation on the surface of silicon. In such a process, it is desirable that the wafer laminate has resistance over a wide range in a high temperature region up to about 400°C. In particular, it is preferable that the wafer laminate has strength and life even at a temperature of 300°C or higher.

[Step (c)]

Step (c) involves peeling the support from the thin wafer laminate processed in step (b), more specifically, separating the support from the laminate by laser irradiation from the support side of the laminate. This peeling step is generally carried out under a relatively low temperature condition of about room temperature, the step preferably including:

(c1) adhering a dicing tape to the processed surface (back surface) of the processed wafer;
(c2) sucking a dicing tape surface to a suction surface to vacuum; and
(c3) peeling off the support from a thin wafer laminate, for example, by irradiation with a laser at a wavelength of 355 nm from the support side of the thin wafer laminate. In this manner, the support can be easily peeled off from the wafer laminate, and the subsequent dicing step can be easily performed. It should be noted that as the dicing tape, a well-known tape using polyester, polyethylene film, or the like can be used.

[Optional Step (x)]

Optional step (x) involves peeling off resin layers I and II that remain on the processed semiconductor substrate (wafer) without being decomposed with a laser by tape-peeling after the support is peeled in step (c).

This peeling step is generally carried out under relatively low-temperature conditions of approximately room temperature to 60°C. One example of a peeling method in step (x) involves horizontally fixing the wafer after step (c), bonding a peeling tape material onto the exposed undecomposed resin layer I, and then peeling off the tape material by the peeling method to peel the undecomposed resin layers I and II from the processed wafer.

Any tape capable of peeling may be used as the tape material, but tapes using a silicone pressure-sensitive adhesive are preferred. For example, polyester film pressure-sensitive tapes such as No. 646S and No. 648 manufactured by Teraoka Seisakusho Co., Ltd. are suitably used.

Furthermore, when the tape material is peeled by the peeling method, it is preferable to perform the peeling while heating the laminate, and the heating temperature is preferably from 30°C to 60°C, and more preferably from 35°C to 55°C. In this state where the laminate is heated, the adhesive force between the resin layer II and the wafer is reduced, and the peeling can be performed more easily.

[Step (d)]

After performing step (x), or alternatively, without performing step (x) after step (c), it is preferable to carry out step (d), in which the silicone-based resin layer (resin layer I) and the laser release layer (resin layer II) are removed from the laminate separated in step (c) using a cleaning solution having a temperature ranging from room temperature to 60°C, not exceeding the flash point, to take out only the circuit substrate. That is, this step serves to remove the temporary adhesive agent layer remaining on the circuit-forming surface of the peeled wafer. In some cases, the resin layer II may slightly remain on the circuit-formed surface of the semiconductor substrate (wafer) peeled off in step (x), and the resin layer II can be removed, for example, by cleaning the wafer. When step (x) is not performed, a larger amount of resin layer II often remains.

In step (d), a cleaning solution that dissolves the component of the resin layer II can be used, and specific examples thereof include pentane, hexane, cyclohexane, decane, isononane, p-menthane, pinene, isododecane, and limonene. These solvents may be used singly or in combination with two or more thereof. If it is difficult to remove, a base or an acid may be added to the solvent. Examples of the base that can be used include: amines such as ethanol amine, diethanol amine, triethanol amine, triethylamine, and ammonia; and ammonium salts such as tetramethyl ammonium

hydroxide. Examples of the acid that can be used include organic acids such as acetic acid, oxalic acid, benzenesulfonic acid, and dodecylbenzenesulfonic acid. The addition amount is from 0.01 to 10% by mass, preferably from 0.1 to 5% by mass in terms of the concentration in the cleaning solution. To improve the removability of the residue, the existing surfactant may be added. The cleaning method may include cleaning with a paddle using the solution, cleaning using spraying, or immersion in a cleaning solution tank. The temperature is preferably from 10°C to 80°C, preferably from 15°C to 65°C, and if necessary, the resin layer II is dissolved in a dissolving solution thereof, finally washed with water or rinsed with an alcohol, followed by drying treatment, to obtain a thin wafer.

As described above, a thin wafer can ultimately be obtained by combining a support, a resin layer, and a substrate having a circuit on the surface, peeling off the support, and further removing a residual resin layer by cleaning (or optionally by tape peeling) to peel off the resin layer.

EXAMPLE

Hereinafter, the present invention is described in more detail with reference to Preparation Examples, Examples, and Comparative Examples, but the present invention is not limited to these Examples. It should be noted that in the following examples, "parts" refer to parts by mass. The weight average molecular weight (Mw) and number average molecular weight (Mn) are a measured value in terms of polystyrene determined by GPC using THF as a solvent. Besides, an acid generator AG used in the following examples is as follows.

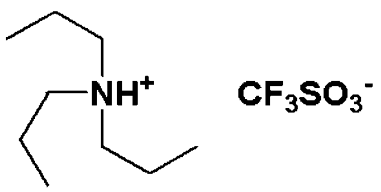

[1] Preparation of Resin Solution

[Preparation Example 1]

To a solution containing 100 parts by mass of dimethylpolysiloxane with a Mn of 30,000 having 2.5 mol% of $(CH_2=CH)(CH_3)SiO_{2/2}$ units ($D^{Vi}$ units) and 200 parts by mass of p-menthane, a solution containing 15 parts by mass of vinylmethylpolysiloxane with a Mn of 7,000 composed of 50 mol% of $SiO_{4/2}$ units (Q units), 48 mol% of $(CH_3)_3SiO_{1/2}$ units (M units), and 2 mol% of $(CH_2=CH)_3SiO_{1/2}$ units (Vi units) and 70 parts by mass of p-menthane, a solution containing 2 parts by mass of organohydrogenpolysiloxane represented by M-6 with a Mn of 2,400 and 3 parts by mass of p-menthane, and 0.6 parts by mass of 1-ethynylcyclohexanol were added and mixed. In addition, 0.4 parts by mass of catalyst CAT-PL-5 (manufactured by Shin-Etsu Chemical Co., Ltd., platinum concentration: 1.0% by mass) and 1 part by mass of tetrakis [methylene-(3,5-di-tert-butyl-4-hydroxyhydrocinnamate)]methane were added thereto and mixed, and the mixture was then filtered through a membrane filter of 1 μm to prepare a thermosetting silicone resin solution D1. It should be noted that in the resin solution, the molar ratio of the Si-H groups in the organohydrogenpolysiloxane having Si-H groups to the alkenyl groups in the dimethylpolysiloxane having alkenyl groups was 1.0. In addition, the viscosity of the resin solution D1 at 25°C was 2 Pa·s.

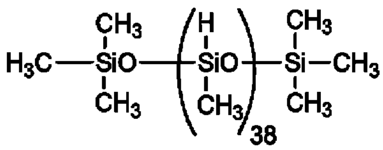

(M−6)

It should be noted that a value of the molar ratio (Si-H/Si-Vi) of the Si-H groups in the organohydrogenpolysiloxane having Si-H groups to the alkenyl groups in the dimethylpolysiloxane having alkenyl groups in Preparation Example 1 is calculated based on the following formula: wherein "PDMS" denotes dimethylpolysiloxane, and "POHS" denotes organohydrogenpolysiloxane.

(1) Si-Vi amount (mol) from component (A-1)

(PDMS addition amount/PDMS molecular weight) × {PDMS molecular weight/ (D unit molecular weight × D unit mol%/100 + $D^{Vi}$ unit molecular weight × D unit mol%/100)} × $D^{Vi}$ unit mol%/100

(2) Si-H amount (mol) from component (A-2)

(POHS addition amount/POHS molecular weight) × number of H-bonded siloxane units per molecule

(3) Value of Si-H/Si-Vi

Si-H amount (mol) from component (A-2) /Si-Vi amount (mol) from component (A-1)

[Preparation Example 2]

To a solution containing 80 parts by mass of dimethyldiphenylpolysiloxane with a Mn of 50,000 having 2.5 mol% of $(CH_2{=}CH)(CH_3)SiO_{2/2}$ units ($D^{Vi}$ units) and 3 mol% of phenyl groups at a molecular side chain and 200 parts by mass of p-menthane, a solution containing 70 parts by mass of vinylmethylpolysiloxane with a Mn of 7,000 composed of 50 mol% of $SiO_{4/2}$ units (Q units), 48 mol% of $(CH_3)_3SiO_{1/2}$ units (M units), and 2 mol% of $(CH_2{=}CH)_3SiO_{1/2}$ units (Vi units) and 70 parts by mass of p-menthane, a solution containing 3 parts by mass of organohydrogenpolysiloxane represented by M-6 with a Mn of 2,400 and 5 parts by mass of p-menthane, and 0.6 parts by mass of 1-ethynylcyclohexanol were added and mixed. In addition, 0.4 parts by mass of catalyst CAT-PL-5 (manufactured by Shin-Etsu Chemical Co., Ltd., platinum concentration: 1.0% by mass) and 1.5 parts by mass of tetrakis[methylene-(3,5-di-tert-butyl-4-hydroxyhydrocinnamate)]methane were added thereto and mixed, and the mixture was then filtered through a membrane filter of 1 μm to prepare a thermosetting silicone resin solution D2. It should be noted that in the resin solution, the molar ratio of the Si-H groups in the organohydrogenpolysiloxane having Si-H groups to the alkenyl groups in the dimethylpolysiloxane having alkenyl groups was 1.0. In addition, the viscosity of the resin solution D2 at 25°C was 1.5 Pa·s.

[Preparation Example 3]

To a solution containing 90 parts by mass of dimethylpolysiloxane with a Mn of 50,000 having 2.5 mol% of $(CH_2{=}CH)(CH_3)SiO_{2/2}$ units ($D^{Vi}$ units) and 200 parts by mass of p-menthane, a solution containing 70 parts by mass of dimethylpolysiloxane with a Mn of 10,000 having 5 mol% of $(CH_2{=}CH)(CH_3)SiO_{2/2}$ units ($D^{Vi}$ units) and 100 parts by mass of p-menthane, a solution containing 5 parts by mass of organohydrogenpolysiloxane represented by M-6 with a Mn of 2,400 and 7 parts by mass of p-menthane, and 0.6 parts by mass of 1-ethynylcyclohexanol were added and then mixed. In addition, 0.4 parts by mass of catalyst CAT-PL-5 (manufactured by Shin-Etsu Chemical Co., Ltd., platinum concentration: 1.0% by mass) and 1 part by mass of tetrakis[methylene-(3,5-di-tert-butyl-4-hydroxyhydrocinnamate)]methane were added thereto and mixed, and the mixture was then filtered through a membrane filter of 1 μm to prepare a thermosetting silicone resin solution D3. It should be noted that in the resin solution, the molar ratio of the Si-H groups in the organohydrogenpolysiloxane having Si-H groups to the alkenyl groups in the dimethylpolysiloxane having alkenyl groups was 1.0. In addition, the viscosity of the resin solution D3 at 25°C was 3 Pa·s.

[Preparation Example 4]

In 100 parts of PGMEA containing 0.1% by mass of KP-341 (manufactured by Shin-Etsu Chemical Co., Ltd), 20 parts of the resin A1 (having a repeating unit of the following structure, with a Mn of 3,200 and a dispersity (Mw/Mn) of 2.44), 1 part of the acid generator AG, and 4 parts of NIKALAC Mw390 (Sanwa Chemical Co., Ltd.) as a crosslinker were dissolved, and the mixture was filtered through a filter formed of fluorine resin of 0.1 μm to obtain a resin composition A1 (laser release agent). It should be noted that the transmittance was 1%, as measured at a wavelength of 355 nm using UV3600i (Shimadzu Corporation).

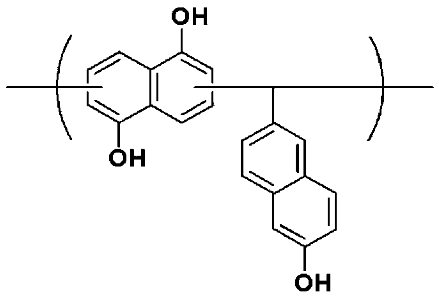

Resin A1

NIKALAC Mw390

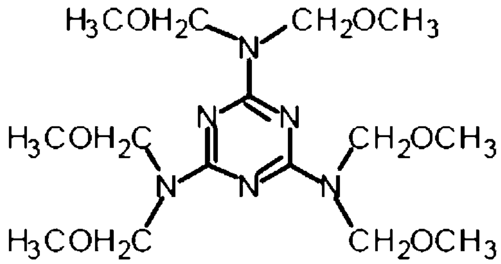

[Comparative Preparation Example 1]

A thermosetting silicone resin solution D4 was prepared in the same manner as in Preparation Example 1, except that tetrakis[methylene-(3,5-di-tert-butyl-4-hydroxyhydrocinnamate)]methane was not added.

[Comparative Preparation Example 2]

To a solution containing 20 parts by mass of dimethylpolysiloxane with a Mn of 30,000 having 2.5 mol% of $(CH_2{=}CH)(CH_3)SiO_{2/2}$ units ($D^{Vi}$ units) and 100 parts by mass of p-menthane, a solution containing 150 parts by mass of vinylmethylpolysiloxane with a Mn of 7,000 composed of 50 mol% of $SiO_{4/2}$ units (Q units), 48 mol% of $(CH_3)_3SiO_{1/2}$ units (M units), and 2 mol% of $(CH_2{=}CH)_3SiO_{1/2}$ units (Vi units) and 140 parts by mass of p-menthane, a solution containing 3 parts by mass of organohydrogenpolysiloxane represented by M-6 with a Mn of 2,400 and 5 parts by mass of p-menthane, and 0.6 parts by mass of 1-ethynylcyclohexanol were added and mixed. In addition, 0.4 parts by mass of catalyst CAT-PL-5 (manufactured by Shin-Etsu Chemical Co., Ltd., platinum concentration: 1.0% by mass) and 1 part by mass of tetrakis [methylene-(3,5-di-tert-butyl-4-hydroxyhydrocinnamate)]methane were added thereto and mixed, and the mixture was then filtered through a membrane filter of 1 μm to prepare a thermosetting silicone resin solution D5. It should be noted that in the resin solution, the molar ratio of the Si-H groups in the organohydrogenpolysiloxane having Si-H groups to the alkenyl groups in the dimethylpolysiloxane having alkenyl groups was 1.0. In addition, the viscosity of the resin solution D5 at 25°C was 0.9 Pa·s.

[2] Fabrication and Evaluation of Wafer

[Examples 1 to 3 and Comparative Examples 1 and 2]

On a glass wafer having a diameter of 200 mm (thickness: 700 μm), the resin composition A1 (laser release agent) was applied by spin coating and heated on a hot plate at 120°C for 2 minutes and then at 250°C for 5 minutes to form a film of the material corresponding to the resin layer I (laser release layer) with the film thickness shown in Table 1.

Furthermore, on a silicon wafer having a diameter of 200 mm (thickness: 725 μm), D1 to D5 were applied by spin coating and heated on a hot plate at 100°C for 2 minutes to form a resin layer II with the film thickness shown in Table 1.

The glass plate-resin layer I and the resin layer II-wafer surface were bonded together in a vacuum bonding device (EVG520IS, manufactured by EVG) under a reduced pressure of 1 Pa or less under the conditions shown in Table 1, and then heated on a hot plate at 150°C for 10 minutes to fabricate a wafer laminate.

After that, the bonded substrate was tested as described below. The results are shown in Table 1. It should be noted that the evaluations were performed in the following order.

(1) Adhesion test

Wafers having a diameter of 200 mm were bonded together with the wafer bonding device EVG520IS manufactured by EVG. The bonding temperature was the values shown in Table 1, the pressure in the chamber in bonding was 1 Pa or less, and the load was applied from D1 to D5. After the bonding, the temperature was decreased to room temperature, and the subsequent bonded state at the interface was observed with eyes and an optical microscope respectively. The wafer free of abnormalities such as bubbles at the interface was evaluated as good and shown as "Good", and the wafer with the abnormalities was evaluated as defective and shown as "Poor".

(2) Heat resistance test

The attached wafers were placed in a hot air circulation oven at 260°C and left for 2 hours. Thereafter, the wafers were taken out from the oven, cooled to room temperature, and observed the wafer state with eyes. The wafer free of abnormalities such as bubbles at the interface was evaluated as good and shown as "Good", and the wafer with the abnormalities was evaluated defective and shown as "Poor".

(3) Support peelability test

The peelability of the support was evaluated by the following method: a dicing tape was first pasted on the wafer side of the wafer laminate using a dicing frame, and this dicing tape surface was set to a suction plate by vacuum suction. Thereafter, the entire surface was irradiated with a laser at a wavelength of 355 nm from the support side. A case where the support and the wafer could be peeled without cracking was shown as "Good", and a case where the support and the wafer could not be peeled or could be peeled but an abnormality such as cracking occurred was evaluated as defective and shown as "Poor".

(4) Dissolution rate test

The dissolution rate test with a solvent was evaluated by the following method: a 200 mm wafer with the remaining resin layer was immersed for 1 minute in a cleaning method using a cleaning solution obtained by dissolving 3% by mass of tetrabutylammonium fluoride in dimethylpropionamide as a cleaning solvent at 50°C with the resin layer facing upward and then filtering the solution through a 1 μm filter, the wafer was further immersed in isopropyl alcohol (IPA) for 1 minute and then placed on a hot plate at 120°C for 3 minutes, and the film thickness was then measured. The dissolution rate was determined based on the following equation.

Dissolution rate = ((thickness after coating on silicon wafer) - (thickness after cleaning test))/(cleaning solution immersion time)

[Table 1]

| Item | Example 1 | Example 2 | Example 3 | Comparative Example 1 | Comparative Example 2 |
|---|---|---|---|---|---|
| Temporary adhesive | D1 | D2 | D3 | D4 | D5 |
| Thickness of temporary adhesive agent layer | 50μm | 50μm | 50μm | 50μm | 50μm |
| Laser release layer | 0.5mm | 0.5mm | 0.5mm | 0.5mm | 0.5mm |
| Heat resistance enhancer | present | present | present | absent | present |
| Proportion of dimethylsiloxane units | 84wt% | 51wt% | 93wt% | 84wt% | 11wt% |
| Bonding condition | 80°C × 3KN | 80°C × 3KN | 60°C × 3KN | 80°C × 3KN | 80°C × 3KN |
| Bonding test | Good | Good | Good | Good | Good |
| Heat resistance 260°C × 2 hr | Good | Good | Good | Poor | Good |
| Laser peelability | Good | Good | Good | Good | Good |

(continued)

| Item | Example 1 | Example 2 | Example 3 | Comparative Example 1 | Comparative Example 2 |
|---|---|---|---|---|---|
| Dissolution rate | µm/min | 25 µm/min | µm/min | 15 µm/min | 10 µm/min |

As shown in Table 1, Examples 1 to 3 were found to facilitate temporary adhesion and support peeling and to have high cleaning speed, resulting in excellent cleanability. On the other hand, Comparative Example 1 showed partial wafer peeling in the heat resistance evaluation, and Comparative Example 2 exhibited a lower cleaning speed.

The present description includes the following embodiments.

[1]: A silicone-based resin-containing temporary adhesive including a silicone-based resin, configured to temporarily adhere a semiconductor substrate to a support,
wherein a dissolution rate of a temporary adhesive layer formed of the temporary adhesive is 20 µm/min or more, as measured by attaching the semiconductor substrate to the support via the temporary adhesive layer, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by mass of tetrabutylammonium fluoride.
[2]: The silicone-based resin-containing temporary adhesive according to the above [1], wherein a proportion of dimethylsiloxane units in a nonvolatile component of the silicone-based resin-containing temporary adhesive is 20% by mass or more.
[3]: The silicone-based resin-containing temporary adhesive according to the above [1] or [2], comprising a heat resistance enhancer.
[4]: The silicone-based resin-containing temporary adhesive according to any of the above [1] to [3], wherein the silicone-based resin is a curable silicone resin, the curable silicone resin being formulated as a composition comprising:

(A) an organopolysiloxane having two or more alkenyl groups per molecule;
(B) an organohydrogenpolysiloxane having two or more silicon atom-bonded hydrogen atoms (Si-H groups) per molecule; and
(C) a platinum-based catalyst,

in such an amount that a molar ratio of the Si-H groups in the component (B) to the alkenyl groups in the component (A) is from 0.3 to 10.
[5]: The silicone-based resin-containing temporary adhesive according to any of the above [1] to [4], which is used in combination with a laser release agent when the semiconductor substrate is temporarily adhered to the support.
[6]: A method for processing a circuit substrate, comprising the steps of:

(a) providing a laminate comprising a circuit substrate as the semiconductor substrate and the support, which are temporarily adhered to each other via a silicone-based resin layer formed using the silicone-based resin-containing temporary adhesive according to the above [5] and a laser release layer formed using the laser release agent;
(b) processing a back surface of the laminate;
(c) separating the support from the laminate by laser irradiation from a support side; and
(d) removing the silicone-based resin layer and the laser release layer from the separated laminate using a cleaning solution having a temperature of 40°C to 60°C to take out only the circuit substrate.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A silicone-based resin-containing temporary adhesive comprising a silicone-based resin, configured to temporarily adhere a semiconductor substrate to a support,

wherein a dissolution rate of a temporary adhesive layer formed of the temporary adhesive is 20 μm/min or more, as measured by attaching the semiconductor substrate to the support via the temporary adhesive layer, performing heating at 260°C for 2 hours and then peeling off the semiconductor substrate and the support, and then dissolving the temporary adhesive layer remaining on the semiconductor substrate or the support in a dimethylpropionamide solution at 50°C containing 3% by mass of tetrabutylammonium fluoride.

**2.** The silicone-based resin-containing temporary adhesive according to claim 1, wherein a proportion of dimethylsiloxane units in a nonvolatile component of the silicone-based resin-containing temporary adhesive is 20% by mass or more.

**3.** The silicone-based resin-containing temporary adhesive according to claim 1, comprising a heat resistance enhancer.

**4.** The silicone-based resin-containing temporary adhesive according to any one of claims 1 to 3, wherein the silicone-based resin is a curable silicone resin, the curable silicone resin being formulated as a composition comprising:

(A) an organopolysiloxane having two or more alkenyl groups per molecule;
(B) an organohydrogenpolysiloxane having two or more silicon atom-bonded hydrogen atoms (Si-H groups) per molecule; and
(C) a platinum-based catalyst,

in such an amount that a molar ratio of the Si-H groups in the component (B) to the alkenyl groups in the component (A) is from 0.3 to 10.

**5.** The silicone-based resin-containing temporary adhesive according to any one of claims 1 to 4, which is used in combination with a laser release agent when the semiconductor substrate is temporarily adhered to the support.

**6.** A method for processing a circuit substrate, comprising the steps of:

(a) providing a laminate comprising a circuit substrate as the semiconductor substrate and the support, which are temporarily adhered to each other via a silicone-based resin layer formed using the silicone-based resin-containing temporary adhesive according to claim 5 and a laser release layer formed using the laser release agent;
(b) processing a back surface of the laminate;
(c) separating the support from the laminate by laser irradiation from a support side; and
(d) removing the silicone-based resin layer and the laser release layer from the separated laminate using a cleaning solution having a temperature of 40°C to 60°C to take out only the circuit substrate.

## INTERNATIONAL SEARCH REPORT

International application No.
**PCT/JP2024/009179**

**A. CLASSIFICATION OF SUBJECT MATTER**

***H01L 21/02***(2006.01)i; ***C09J 11/06***(2006.01)i; ***C09J 11/08***(2006.01)i; ***C09J 183/04***(2006.01)i; ***C09J 183/05***(2006.01)i
FI: H01L21/02 B; C09J183/04; C09J11/06; C09J183/05; C09J11/08

According to International Patent Classification (IPC) or to both national classification and IPC

**B. FIELDS SEARCHED**

Minimum documentation searched (classification system followed by classification symbols)

H01L21/02; C09J11/06; C09J11/08; C09J183/04; C09J183/05

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2021/112070 A1 (SHIN-ETSU CHEMICAL CO., LTD.) 10 June 2021 (2021-06-10) | 1-6 |
| A | WO 2021/220929 A1 (SHIN-ETSU CHEMICAL CO., LTD.) 04 November 2021 (2021-11-04) | 1-6 |
| A | JP 2020-12020 A (SHIN-ETSU CHEMICAL CO., LTD.) 23 January 2020 (2020-01-23) | 1-6 |
| A | WO 2021/157191 A1 (SHIN-ETSU CHEMICAL CO., LTD.) 12 August 2021 (2021-08-12) | 1-6 |
| A | JP 2022-144612 A (NISSAN CHEMICAL CORP.) 03 October 2022 (2022-10-03) | 1-6 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 April 2024** | **14 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/009179**

| Patent document cited in search report | Publication date (day/month/year) | Patent family member(s) | Publication date (day/month/year) |
|---|---|---|---|
| WO 2021/112070 A1 | 10 June 2021 | US 2023/0002647 A1<br>EP 4071223 A1<br>KR 10-2022-0108799 A<br>CN 114868232 A | |
| WO 2021/220929 A1 | 04 November 2021 | US 2023/0088354 A1<br>EP 4144808 A1<br>CN 115485814 A<br>KR 10-2023-0005219 A | |
| JP 2020-12020 A | 23 January 2020 | (Family: none) | |
| WO 2021/157191 A1 | 12 August 2021 | US 2023/0348758 A1<br>EP 4101905 A1<br>CN 115038767 A<br>KR 10-2022-0137686 A | |
| JP 2022-144612 A | 03 October 2022 | KR 10-2022-0131172 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003177528 A